# EUROPEAN PATENT APPLICATION

(11) **EP 3 982 411 A1**
(43) Date of publication of application: **13.04.2022**
(21) Application number: 20818825.0
(22) Date of filing: 09.04.2020
(51) Int. Cl.: H01L 27/146, H04N 5/369, H04N 5/3745

(54) **IMAGING ELEMENT AND IMAGING DEVICE**

(30) Priority: 07.06.2019 JP 2019106639
(71) Applicant: Sony Semiconductor Solutions Corporation, Atsugi-shi Kanagawa 243-0014 (JP)
(72) Inventor: KUNITAKE Sachihito, Kikuchi-gun, Kumamoto 869-1102 (JP); NOUDO Shinichiro, Kikuchi-gun, Kumamoto 869-1102 (JP); MASAGAKI Atsushi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2020/015949
(87) International publication number: WO 2020/246133

(57) **Abstract**

Leakage of incident light to a charge holding part is reduced in a back surface irradiation type imaging element.

The imaging element includes a photoelectric conversion part, a reflection part, and a reflection part formation member. The photoelectric conversion part is formed in a semiconductor substrate and performs photoelectric conversion of incident light. The reflection part is disposed in a front surface of the semiconductor substrate, which is different from a surface on which the incident light is incident, to reflect transmitted light transmitted through the photoelectric conversion part to the photoelectric conversion part. The reflection part formation member has a bottom surface disposed adjacent to the front surface of the semiconductor substrate and a side on which the reflection part is formed.

## Description

### [Technical Field]

The present disclosure relates to an imaging element and an imaging device. Specifically, the present disclosure relates to a back surface irradiation type imaging element and an imaging device including the imaging element.

### [Background Art]

Conventionally, an imaging element configured as a back surface irradiation type is used in a complementary metal oxide semiconductor (CMOS) type imaging element. In this imaging element, incident light is radiated to a back surface that is a side different from a front surface side on which a wiring region is disposed in a semiconductor substrate on which a photoelectric conversion unit that performs photoelectric conversion of the incident light in each pixel is formed. Since incident light is radiated to the semiconductor substrate without passing through the wiring region, the back surface irradiation type imaging element can improve sensitivity as compared to a front surface irradiation type imaging element in which incident light is radiated to the side of the front surface of a semiconductor substrate.

In addition, an imaging element that performs global shutter type imaging is used in order to reduce image distortion. This imaging element includes a charge holding part for storing charges generated through photoelectric conversion for each pixel. In this global shutter type imaging, imaging is performed in the following order. First, photoelectric conversion (exposure) is simultaneously performed in all pixels of the imaging element. Next, an image signal is generated for each pixel and transferred on the basis of charges generated through photoelectric conversion. A plurality of pixels disposed in the imaging element are arranged in a two-dimensional lattice form, and transfer of the image signal is sequentially executed for each row of the plurality of pixels. The charges generated through photoelectric conversion are transferred to the charge holding part and held therein after an exposure period ends. The held charges are extracted from the charge holding part immediately before transfer of an image signal and provided for image signal generation. In such a global shutter type imaging element, when some incident light is radiated to the charge holding part, photoelectric conversion occurs in the charge holding part. Charges caused by this photoelectric conversion are added to the held charges, generating noise in an image signal. Accordingly, picture quality deteriorates.

As an imaging element for preventing irradiation of incident light to such a charge holding part, an imaging element in which a light-shielding part is disposed around a charge holding part is proposed (refer to PTL 1, for example). The light-shielding part is composed of a lid part disposed on the side of the back surface of a semiconductor substrate near the charge holding part and an embedded part embedded in the semiconductor substrate between a photoelectric conversion part and the charge holding part and shields incident light. The embedded part is formed from the side of the back surface of the semiconductor substrate toward the front surface thereof. Charges in the photoelectric conversion part are transferred to the charge holding part through a semiconductor region between the edge of the embedded part and the front surface of the semiconductor substrate.

### [Citation List]

### [Patent Literature]

### [PTL 1]

JP 2015-228510 A

### [Summary]

### [Technical Problem]

The above-described conventional technology has the problem that leakage of incident light through the semiconductor region between the edge of the embedded part constituting the light-shielding part and the front surface of the semiconductor substrate cannot be prevented. Among incident light radiated to the photoelectric conversion part, incident light that has passed through the semiconductor substrate without contributing to photoelectric conversion is reflected by wires disposed in a wiring area and the like and become reflected light. This reflected light is incident on the charge holding part through the semiconductor region between the edge of the embedded part and the front surface of the semiconductor substrate, causes photoelectric conversion, and becomes noise. Accordingly, the above-described conventional technology has the problem of picture quality deterioration.

The present disclosure was devised in view of the above-described problems and an object of the present disclosure is to reduce leakage of incident light to a charge holding part and the like.

### [Solution to Problem]

A first aspect of the present disclosure devised to solve the above-described problems is an imaging element including a photoelectric conversion part that is formed in a semiconductor substrate and performs photoelectric conversion of incident light, a reflection part that is disposed in a front surface of the semiconductor substrate which is different from a surface on which the incident light is incident and reflects transmitted light transmitted through the photoelectric conversion part to the photoelectric conversion part, and a reflection part formation member having a bottom surface disposed adjacent to the front surface of the semiconductor substrate and a side on which the reflection part is formed.

Furthermore, in the first aspect, the imaging element may further include an image signal generation circuit that generates an image signal on the basis of charges generated through the photoelectric conversion.

Furthermore, in the first aspect, the reflection part formation member may be formed simultaneously with a gate of a MOS transistor disposed in the image signal generation circuit.

Furthermore, in the first aspect, the reflection part formation member may be formed of the gate of the MOS transistor disposed in the image signal generation circuit.

Furthermore, in the first aspect, the reflection part formation member may have a sidewall insulating film disposed on the side part, and the reflection part may be formed adjacent to the sidewall insulating film.

Furthermore, in the first aspect, the reflection part may be disposed near a boundary of the photoelectric conversion part in the semiconductor substrate.

Furthermore, in the first aspect, the imaging element may further include a light-shielding film that is formed adjacent to an upper surface of the reflection part formation member, which is a surface opposite to the bottom surface, to shield the transmitted light.

Furthermore, in the first aspect, the imaging element may further include a charge holding part that holds the charges generated through the photoelectric conversion.

Furthermore, in the first aspect, the imaging element may further include a light-shielding wall disposed between the photoelectric conversion part in the semiconductor substrate and the charge holding part.

Furthermore, in the first aspect, the light-shielding wall may include an opening near the front surface of the semiconductor substrate, and the reflection part may be disposed near the opening of the light-shielding wall.

Furthermore, in the first aspect, the reflection part may be disposed to be shifted toward the charge holding part from the opening of the light-shielding wall.

Furthermore, in the first aspect, the reflection part formation member may be formed by laminating a plurality of films.

Furthermore, in the first aspect, the imaging element may further include an image signal generation circuit that generates an image signal on the basis of the charges generated through the photoelectric conversion, wherein any one of the plurality of films of the reflection part formation member may be formed simultaneously with a gate of a MOS transistor of the image signal generation circuit.

Furthermore, in the first aspect, a bias voltage may be applied to the reflection part formation member.

Furthermore, in the first aspect, the side of reflection part formation member may be formed in a curved shape.

Furthermore, in the first aspect, the reflection part formation member may include a side having a cross section in a tapered shape.

Furthermore, in the first aspect, the imaging element may further include a color filter through which incident light with a predetermined wavelength is transmitted, wherein the photoelectric conversion part may perform photoelectric conversion of incident light transmitted through the color filter.

Furthermore, in the first aspect, the imaging element may include a plurality of pixels each having the photoelectric conversion part and the color filter, wherein the reflection part and the reflection part formation member may be disposed in a pixel in which the color filter through which the incident light with a long wavelength is transmitted is disposed among the plurality of pixels.

Furthermore, in the first aspect, the reflection part may be formed of a metal.

Furthermore, a second aspect of the present disclosure is an imaging device including a photoelectric conversion part that is formed in a semiconductor substrate and performs photoelectric conversion of incident light, a reflection part that is disposed in a front surface of the semiconductor substrate which is different from a surface on which the incident light is incident and reflects transmitted light transmitted through the photoelectric conversion part to the photoelectric conversion part, a reflection part formation member having a bottom surface disposed adjacent to the front surface of the semiconductor substrate and a side on which the reflection part is formed, and a processing circuit that processes an image signal generated on the basis of charges generated through the photoelectric conversion.

By employing the above-described aspects, the effect that transmitted light of the photoelectric conversion part is reflected toward the photoelectric conversion part is obtained. Accordingly, reduction in leakage of the transmitted light from the photoelectric conversion part is conceived.

### [Brief Description of Drawings]

[Fig. 1]

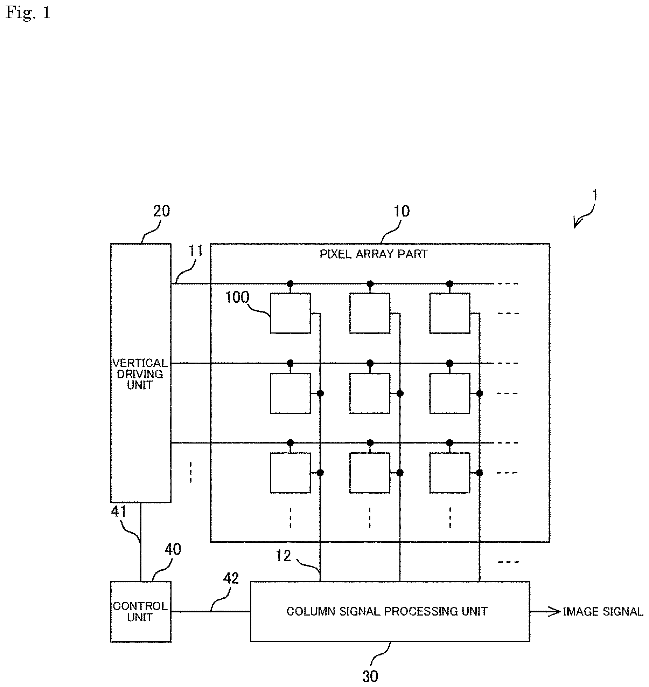

   Fig. 1 is a diagram illustrating a configuration example of an imaging element according to an embodiment of the present disclosure.
[Fig. 2]

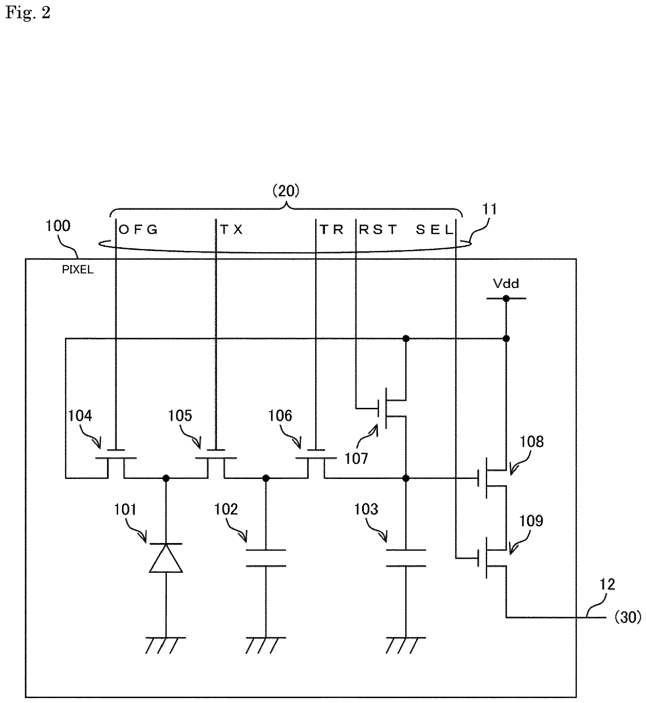

   Fig. 2 is a diagram illustrating an example of a circuit configuration of a pixel according to a first embodiment of the present disclosure.
[Fig. 3]

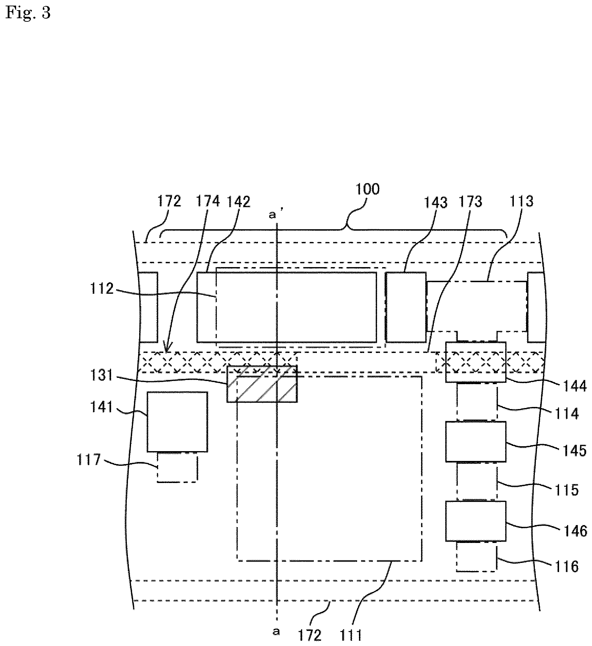

   Fig. 3 is a diagram illustrating a configuration example of the pixel according to the first embodiment of the present disclosure.
[Fig. 4]

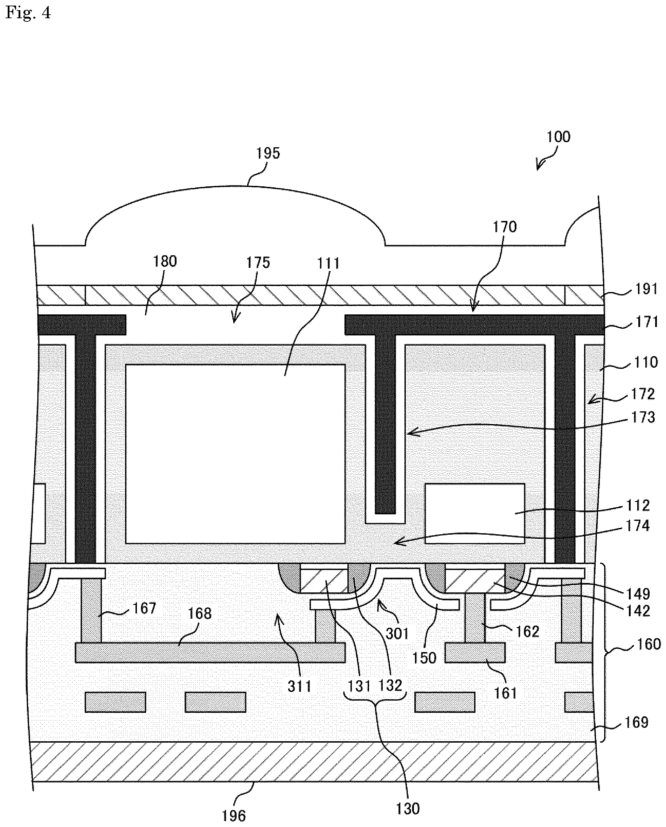

   Fig. 4 is a cross-sectional view illustrating a configuration example of the pixel according to the first embodiment of the present disclosure.
[Fig. 5]

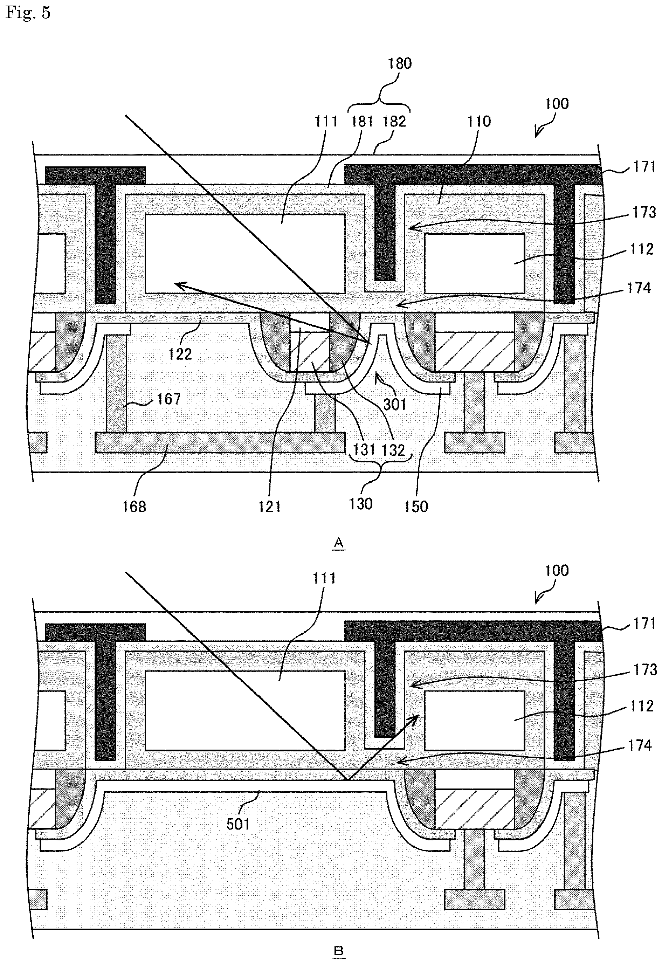

   Fig. 5 is a diagram illustrating an example of reflection of transmitted light according to the first embodiment of the present disclosure.
[Fig. 6]

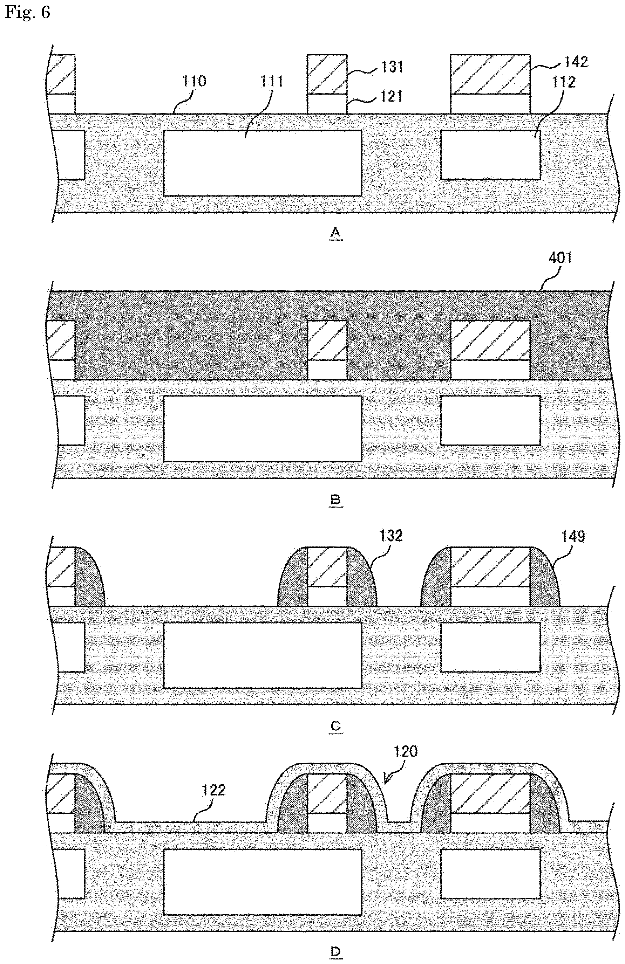

   Fig. 6 is a diagram illustrating an example of a method for manufacturing an imaging element according to the first embodiment of the present disclosure.
[Fig. 7]

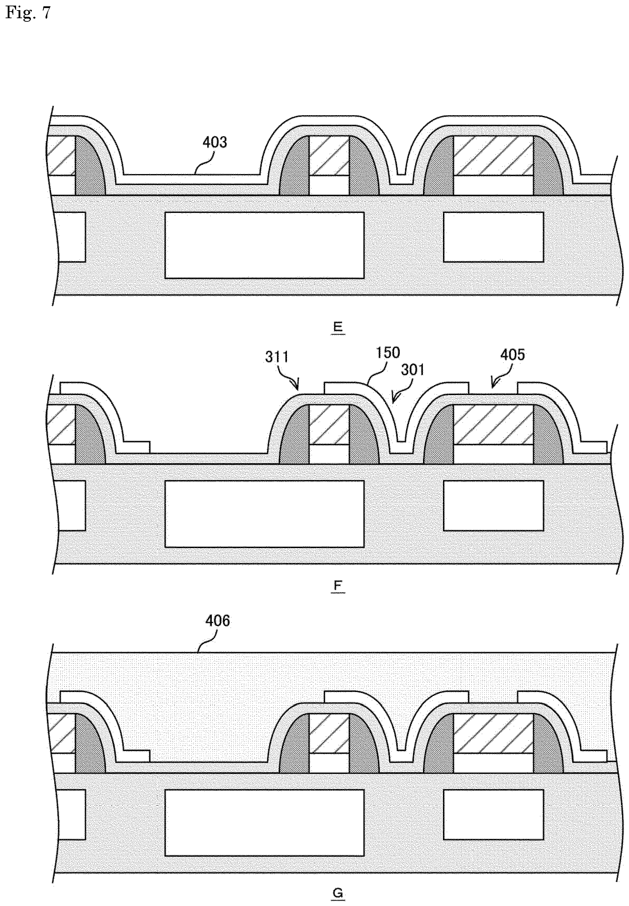

   Fig. 7 is a diagram illustrating an example of a method for manufacturing an imaging element according to the first embodiment of the present disclosure.
[Fig. 8]

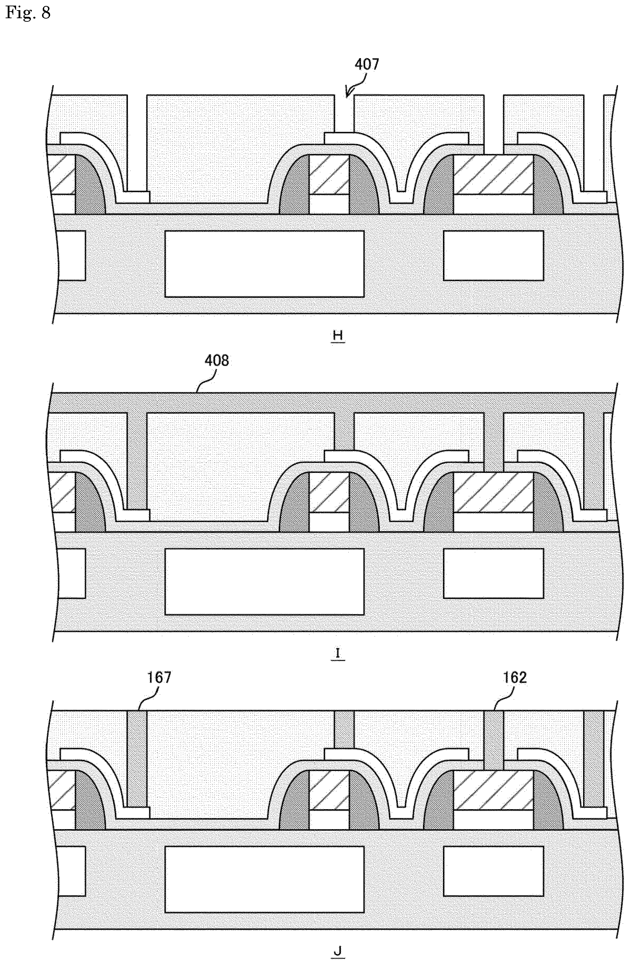

   Fig. 8 is a diagram illustrating an example of a method for manufacturing an imaging element according to the first embodiment of the present disclosure.
[Fig. 9]

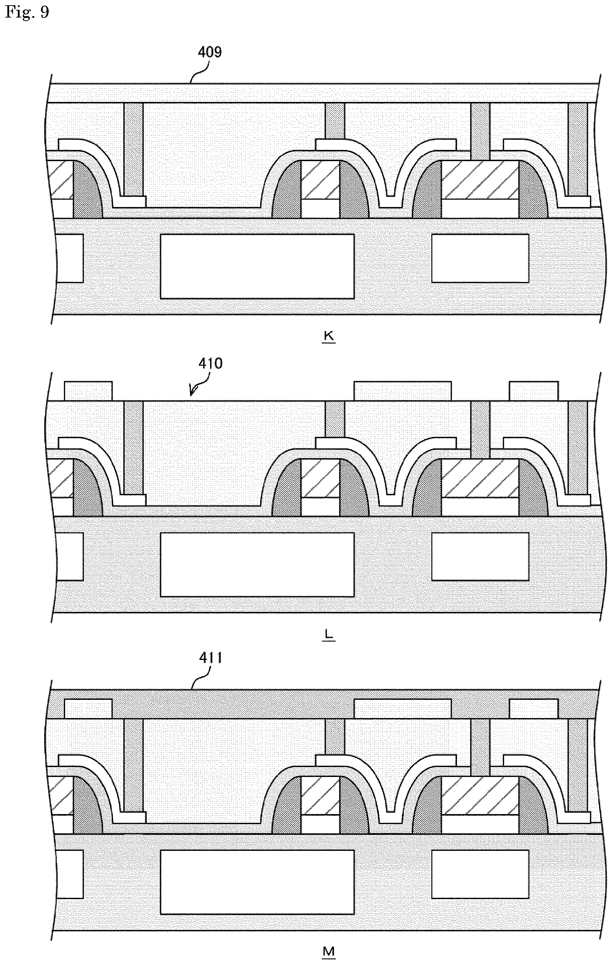

   Fig. 9 is a diagram illustrating an example of a method for manufacturing an imaging element according to the first embodiment of the present disclosure.
[Fig. 10]

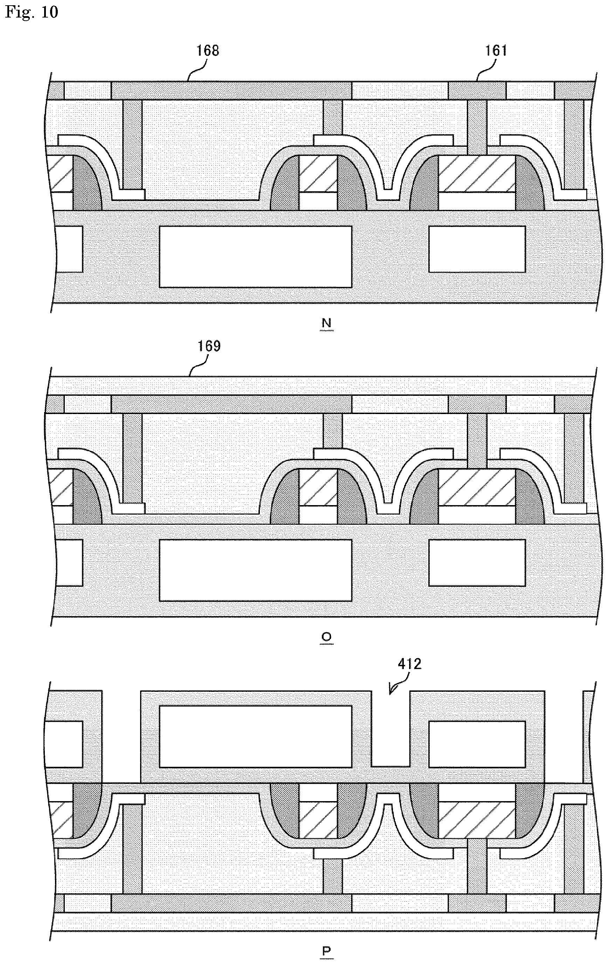

   Fig. 10 is a diagram illustrating an example of a method for manufacturing an imaging element according to the first embodiment of the present disclosure.
[Fig. 11]

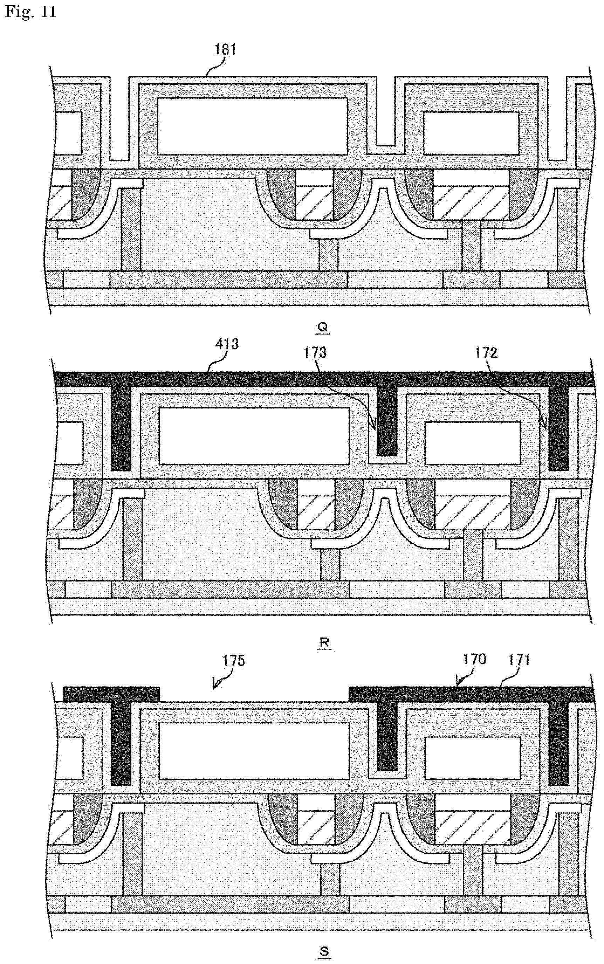

   Fig. 11 is a diagram illustrating an example of a method for manufacturing an imaging element according to the first embodiment of the present disclosure.
[Fig. 12]

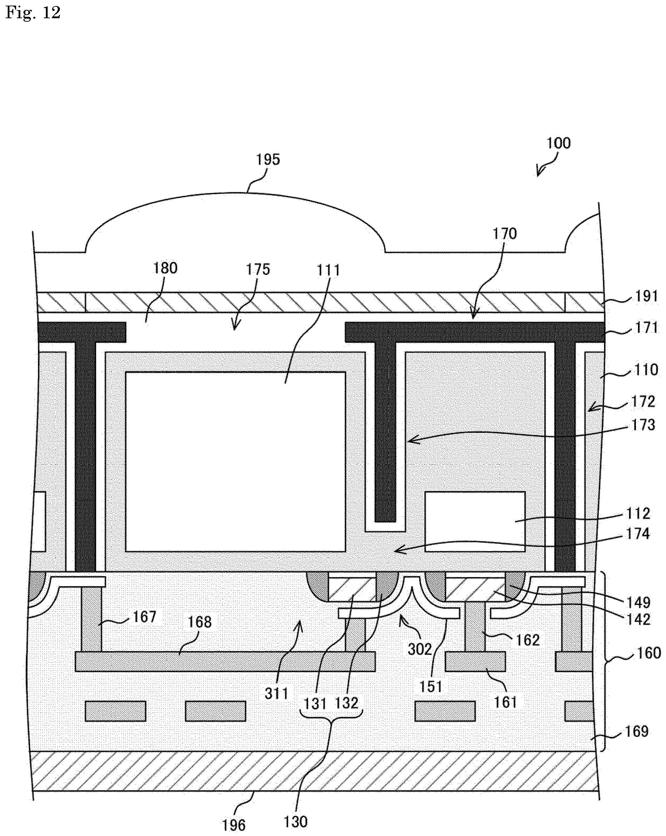

   Fig. 12 is a diagram illustrating a configuration example of a pixel according to a second embodiment of the present disclosure.
[Fig. 13]

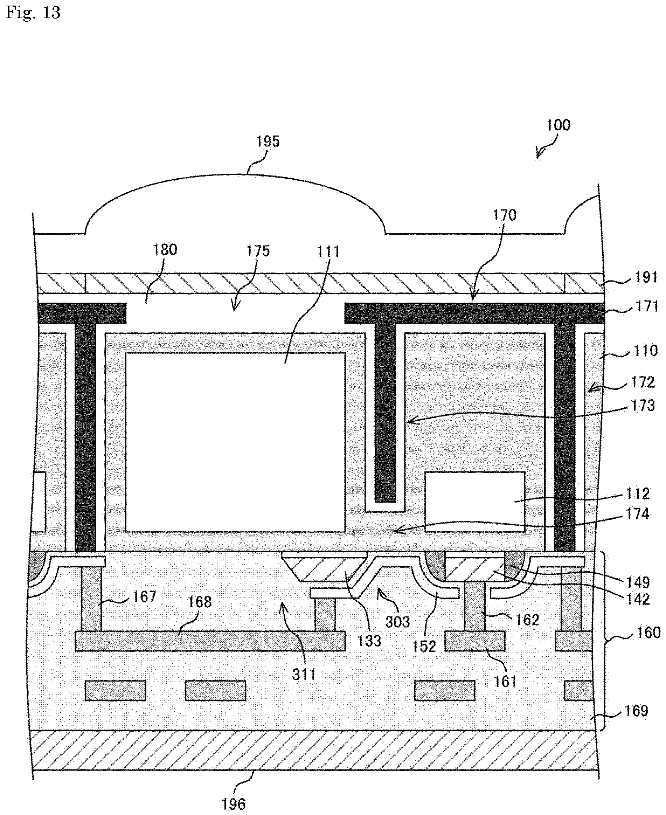

   Fig. 13 is a diagram illustrating a configuration example of a pixel according to a third embodiment of the present disclosure.
[Fig. 14]

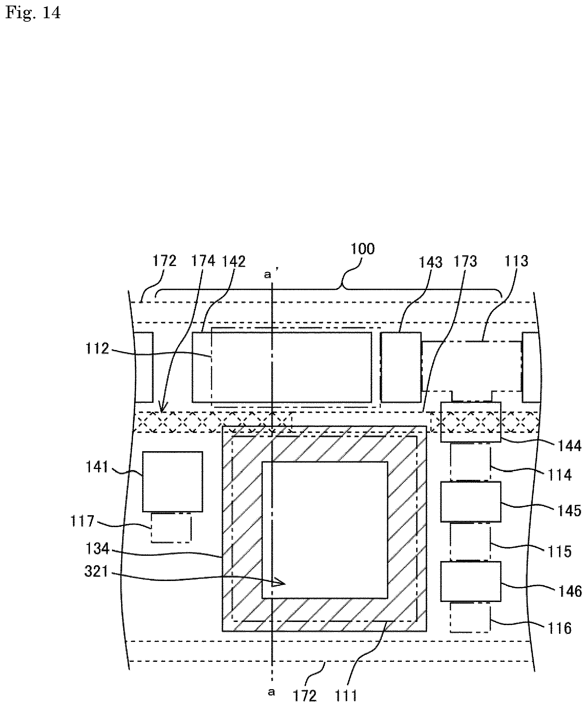

   Fig. 14 is a diagram illustrating a configuration example of a pixel according to a fourth embodiment of the present disclosure.
[Fig. 15]

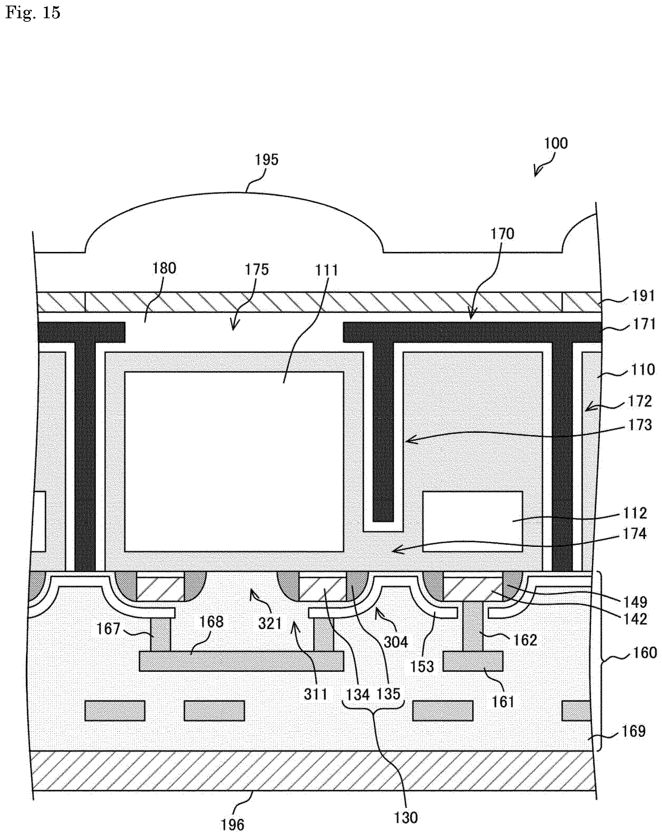

   Fig. 15 is a cross-sectional view illustrating a configuration example of the pixel according to the fourth embodiment of the present disclosure.
[Fig. 16]

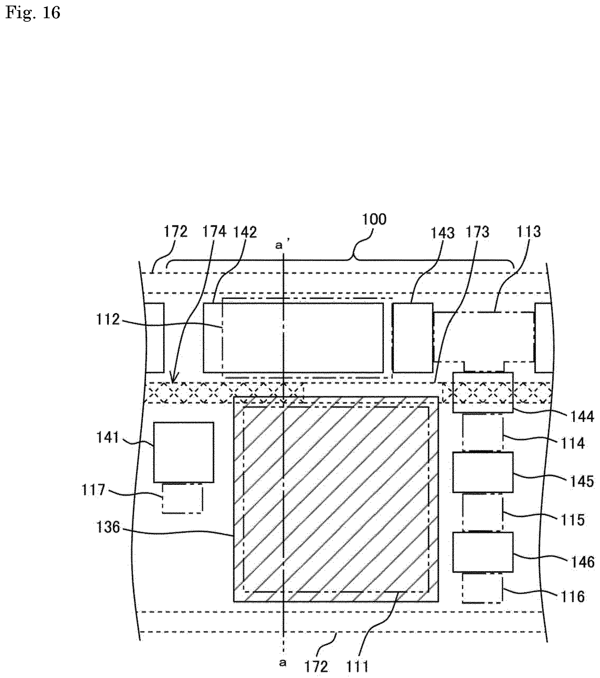

   Fig. 16 is a diagram illustrating a configuration example of a pixel according to a fifth embodiment of the present disclosure.
[Fig. 17]

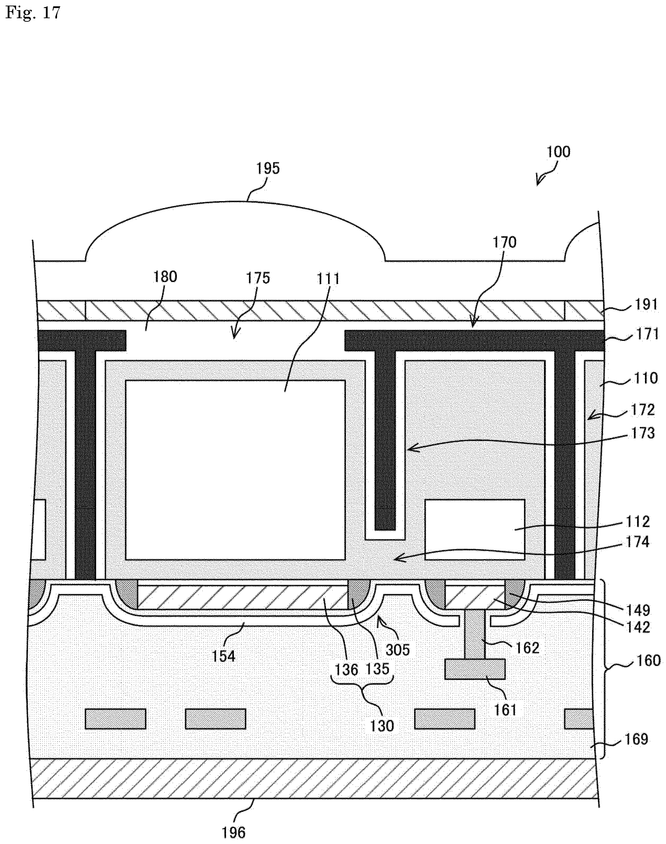

   Fig. 17 is a cross-sectional view illustrating a configuration example of the pixel according to the fifth embodiment of the present disclosure.
[Fig. 18]

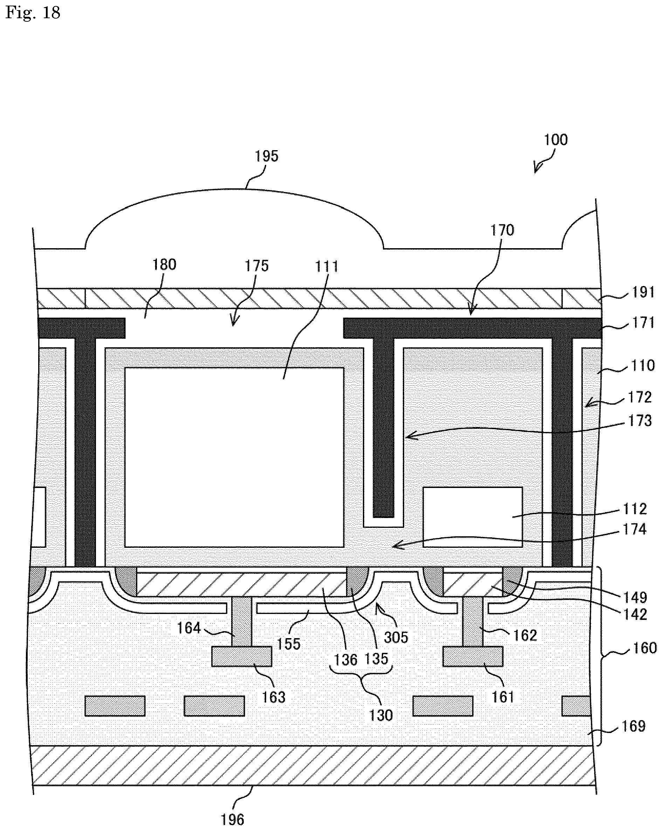

   Fig. 18 is a cross-sectional view illustrating a configuration example of a pixel according to a sixth embodiment of the present disclosure.
[Fig. 19]

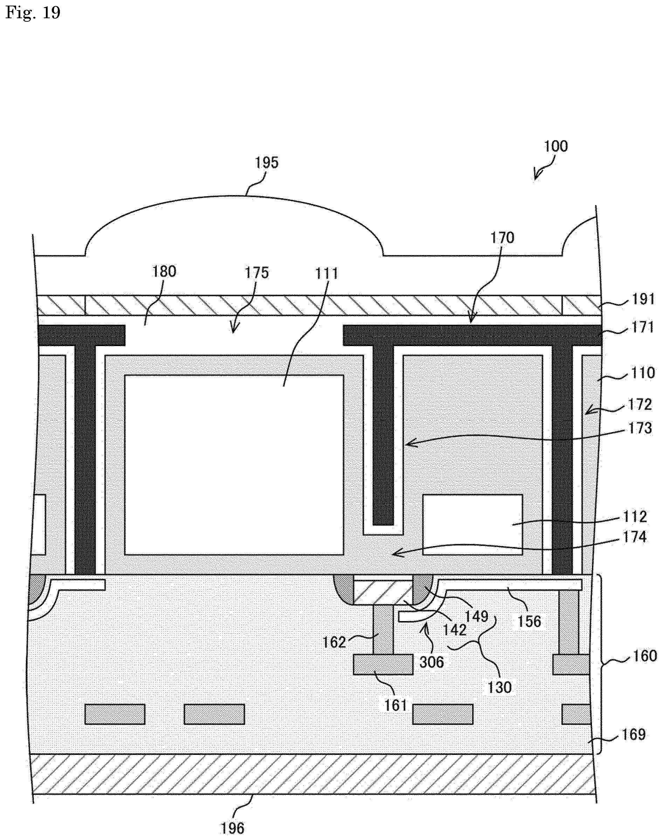

   Fig. 19 is a cross-sectional view illustrating a configuration example of a pixel according to a seventh embodiment of the present disclosure.
[Fig. 20]

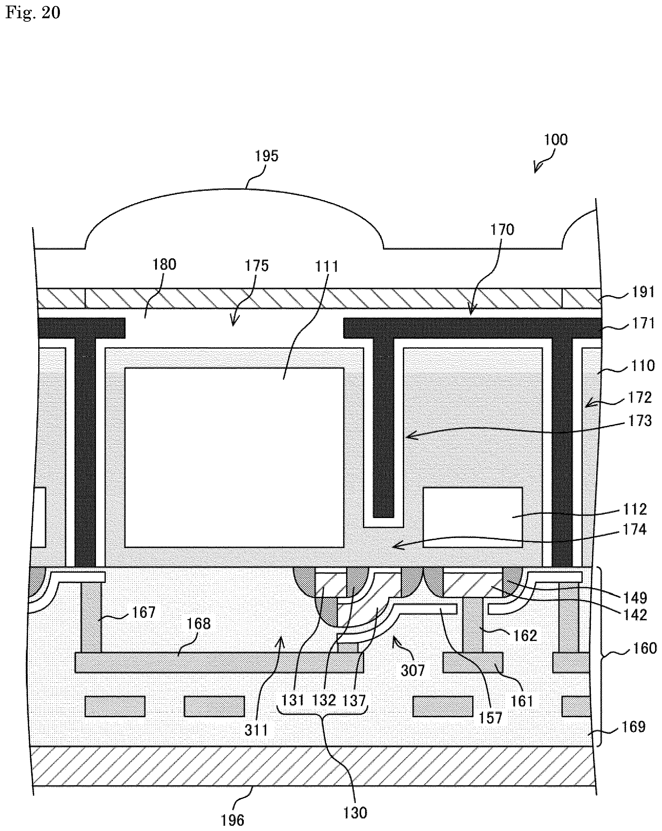

   Fig. 20 is a cross-sectional view illustrating a configuration example of a pixel according to an eighth embodiment of the present disclosure.
[Fig. 21]

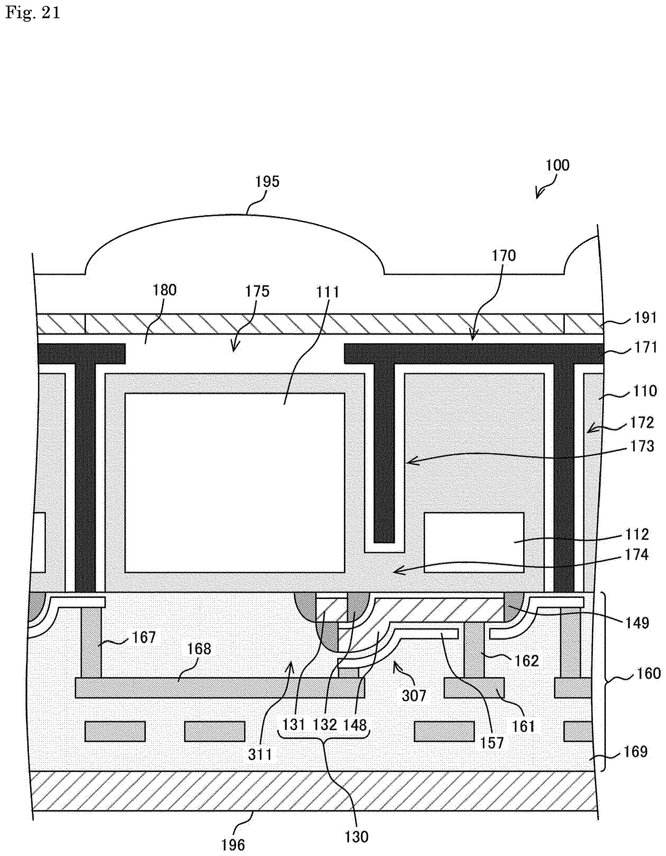

   Fig. 21 is a cross-sectional view illustrating a configuration example of a pixel according to a ninth embodiment of the present disclosure.
[Fig. 22]

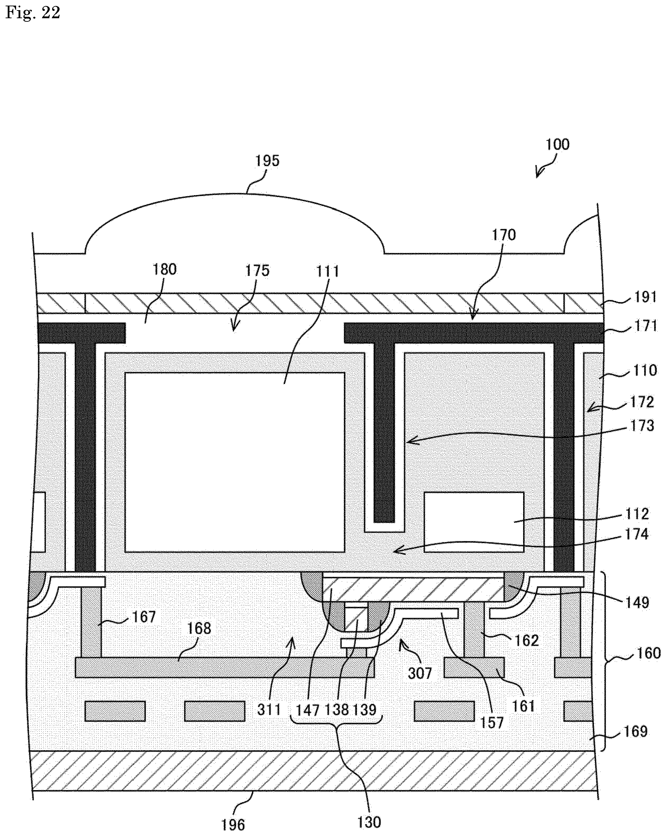

   Fig. 22 is a cross-sectional view illustrating a configuration example of a pixel according to a tenth embodiment of the present disclosure.
[Fig. 23]

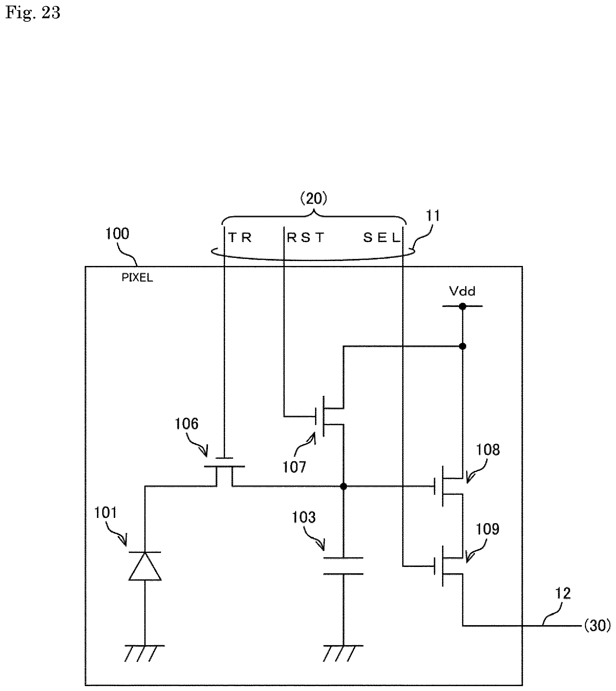

   Fig. 23 is a diagram illustrating an example of a circuit configuration of a pixel according to an eleventh embodiment of the present disclosure.
[Fig. 24]

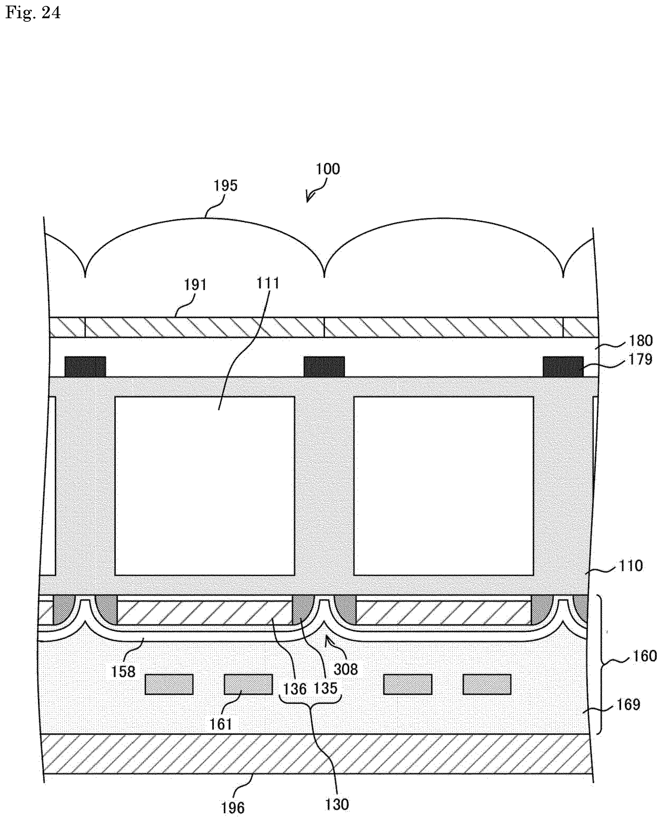

   Fig. 24 is a cross-sectional view illustrating a configuration example of the pixel according to the eleventh embodiment of the present disclosure.
[Fig. 25]

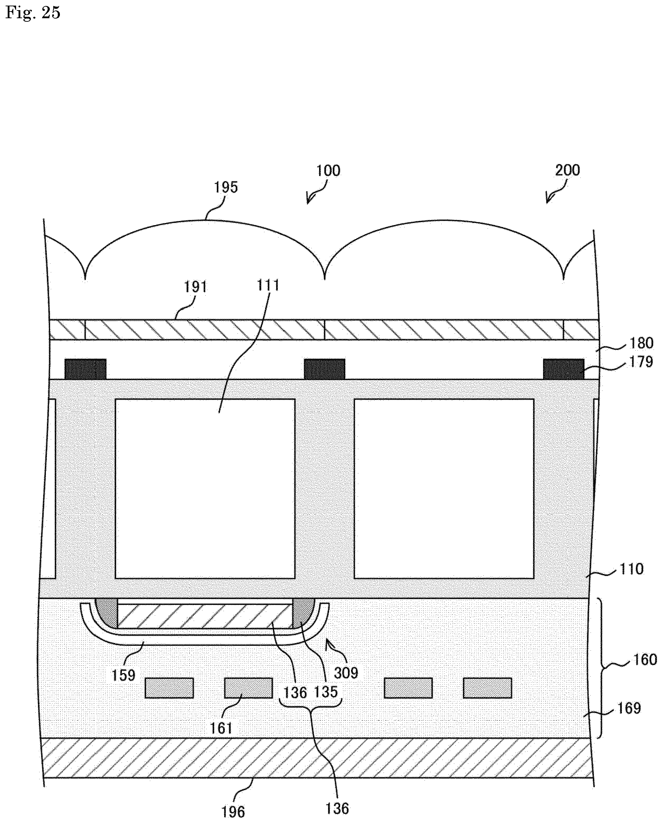

   Fig. 25 is a cross-sectional view illustrating a configuration example of a pixel according to a twelfth embodiment of the present disclosure.
[Fig. 26]

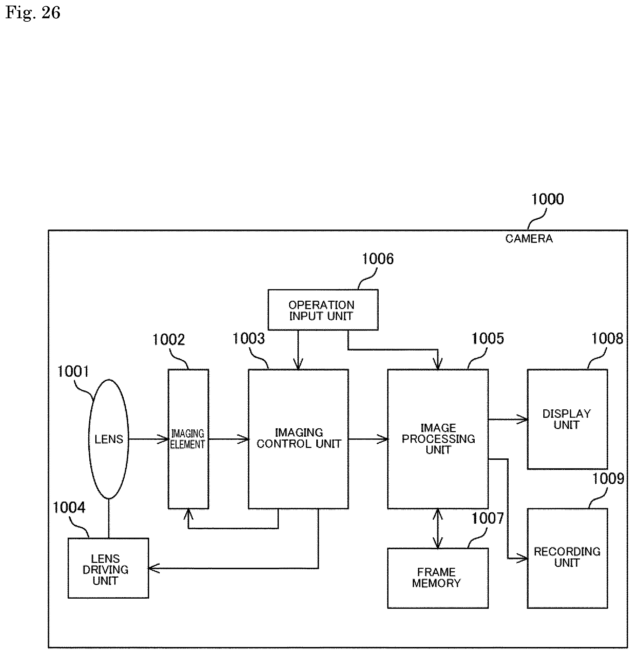

   Fig. 26 is a block diagram illustrating a schematic configuration example of a camera that is an example of an imaging device to which the present technology can be applied.

### [Description of Embodiments]

Next, modes for carrying out the present disclosure (hereinafter referred to as embodiments) will be described with reference to the drawings. In the following drawings, the same or similar parts are denoted by the same or similar reference signs. In addition, embodiments will be described in the following order.
1. First embodiment
2. Second embodiment
3. Third embodiment
4. Fourth embodiment
5. Fifth embodiment
6. Sixth embodiment
7. Seventh embodiment
8. Eighth embodiment
9. Ninth embodiment
10. Tenth embodiment
11. Eleventh embodiment
12. Twelfth embodiment
13. Example of application to camera

### <1. First embodiment>

### [Configuration of imaging element]

Fig. 1 is a diagram illustrating a configuration example of an imaging element according to an embodiment of the present disclosure. In the figure, the imaging element 1 includes a pixel array part 10, a vertical driving unit 20, a column signal processing unit 30, and a control unit 40.

The pixel array part 10 is configured with pixels 100 disposed in a two-dimensional lattice form. Here, the pixels 100 generates image signals in response to radiated light. Each pixel 100 has a photoelectric conversion part that generates charges in response to radiated light. In addition, each pixel 100 further has an image signal generation circuit. The image signal generation circuit generates an image signal based on charges generated by the photoelectric conversion part. Generation of an image signal is controlled by a control signal generated by the vertical driving unit 20 which will be described later. Signal lines 11 and 12 are disposed in an XY matrix form in the pixel array part 10. A signal line 11 is a signal line through which a control signal of the image signal generation circuit in the pixels 100 is transmitted, is disposed for each row of the pixel array part 10, and is commonly wired for pixels 100 disposed in each row. A signal line 12 is a signal line through which an image signal generated by the image signal generation circuit of the pixel 100 is transmitted, is disposed for each column of the pixel array part 10, and is commonly wired for pixels 100 disposed in each column. The photoelectric conversion part and the image signal generation circuit are formed on a semiconductor substrate.

The vertical driving unit 20 generates the control signal of the image signal generation circuits of the pixels 100. The vertical driving unit 20 transmits the generated control signal to the pixels 100 through the signal lines 11 in the figure. The column signal processing unit 30 processes an image signal generated by the pixels 100. The column signal processing unit 30 processes an image signal transmitted from the pixels 100 through the signal lines 12 in the figure. Processing in the column signal processing unit 30 corresponds to, for example, analog-to-digital conversion of converting an analog image signal generated in the pixels 100 into a digital image signal. The image signal processed by the column signal processing unit 30 is output as an image signal of the imaging element 1. The control unit 40 controls the overall imaging element 1. The control unit 40 generates and outputs control signals for controlling the vertical driving unit 20 and the column signal processing unit 30 to control the imaging element 1. The control signals generated by the control unit 40 are transmitted to the vertical driving unit 20 and the column signal processing unit 30 through signal lines 41 and 42. Meanwhile, the column signal processing unit 30 is an example of a processing circuit described in the claims.

### [Circuit configuration of pixel]

Fig. 2 is a diagram illustrating an example of a circuit configuration of a pixel according to a first embodiment of the present disclosure. The figure is a circuit diagram showing a configuration of the pixel 100. In the figure, the pixel 100 includes a photoelectric conversion part 101, a first charge holding part 103, a second charge holding part 102, and MOS transistors 104 to 109. In addition, the signal line 11 composed of signal lines OFG, TX, TR, RST, and SEL and the signal line 12 are wired in the pixel 100. The signal lines OFG, TX, TR, RST, and SEL constituting the signal line 11 are signal lines through which a control signal of the pixel 100 is transmitted. These signal lines are connected to gates of the MOS transistors. A voltage equal to or higher than a threshold voltage across the gates and sources can be applied to the MOS transistors through the signal lines to cause the MOS transistors to be conductive. On the other hand, the signal line 12 is used to transmit an image signal generated by the pixel 100. In addition, a power line Vdd is wired in the pixel 100 to provide power.

An anode of the photoelectric conversion part 101 is grounded and a cathode thereof is connected to the sources of the MOS transistors 104 and 105. The drain of the MOS transistor 104 is connected to the power line Vdd and a gate thereof is connected to the signal line OFG. The drain of the MOS transistor 105 is connected to the source of the MOS transistor 106 and one end of the second charge holding part 102. The other end of the second charge holding part 102 is grounded. The gate of the MOS transistor 105 is connected to the signal line TX and the gate of the MOS transistor 106 is connected to the signal line TR. The drain of the MOS transistor 106 is connected to the source of the MOS transistor 107, the gate of the MOS transistors 108, and one end of the first charge holding part 103. The other end of the first charge holding part 103 is grounded. The gate of the MOS transistor 107 is connected to the signal line RST. The drains of the MOS transistors 107 and 108 are commonly connected to the power line Vdd and the source of the MOS transistor 108 is connected to the drain of the MOS transistor 109. The source of the MOS transistor 109 is connected to the signal line 12 and the gate thereof is connected to the signal line SEL.

The photoelectric conversion part 101 generates charges in response to radiated light and holds the charges as described above. A photodiode can be used for the photoelectric conversion part 101.

The MOS transistor 104 is a transistor that resets the photoelectric conversion part 101. The MOS transistor 104 discharges charges held in the photoelectric conversion part 101 to the power line Vdd to reset the photoelectric conversion part 101 by applying a power supply voltage to the photoelectric conversion part 101. Reset of the photoelectric conversion part 101 by the MOS transistor 104 is controlled by a signal transmitted through the signal line OFG.

The MOS transistor 105 is a transistor that transfers charges generated through photoelectric conversion of the photoelectric conversion part 101 to the second charge holding part 102. Transfer of charges in the MOS transistor 105 is controlled by a signal transmitted through the signal line TX.

The second charge holding part 102 is a capacitor that holds charges transferred by the MOS transistor 105.

The MOS transistor 106 is a transistor that transfers charges held in the second charge holding part 102 to the first charge holding part 103. Transfer of charges in the MOS transistor 106 is controlled by a signal transmitted through the signal line TR.

The MOS transistor 108 is a transistor that generates a signal based on charges held in the first charge holding part 103. The MOS transistor 109 is a transistor that outputs the signal generated by the MOS transistor 108 to the signal line 12 as an image signal. The MOS transistor 109 is controlled by a signal transmitted through the signal line SEL.

The MOS transistor 107 is a transistor that discharges charges held in the first charge holding part 103 to the power line Vdd to reset the first charge holding part 103. This reset by the MOS transistor 107 is controlled by a signal transmitted through the signal line RST.

Generation of an image signal in the pixel 100 in the figure can be performed as follows. First, the MOS transistor 104 is caused to be conductive to reset the photoelectric conversion part 101. Charges generated through photoelectric conversion after the reset are accumulated in the photoelectric conversion part. After a lapse of predetermined time, the MOS transistors 106 and 107 are caused to be conductive to reset the second charge holding part 102. Next, the MOS transistor 105 is caused to be conductive. Accordingly, charges generated in the photoelectric conversion part 101 are transferred to the second charge holding part 102 and held therein. The operation of resetting the photoelectric conversion part 101 to the operation of transferring charges by the MOS transistor 105 are simultaneously performed in all pixels 100 disposed in the pixel array part 10. That is, global reset that is simultaneous reset in all pixels 100 and simultaneous charge transfer in all pixels 100 are executed. Accordingly, a global shutter is realized. Meanwhile, a period from reset of the photoelectric conversion part 101 to charge transfer by the MOS transistor 105 corresponds to an exposure period.

Next, the MOS transistor 107 is caused to be conductive again to reset the first charge holding part 103. Next, the MOS transistor 106 is caused to be conductive such that charges held in the second charge holding part 102 are transferred to the first charge holding part 103 and held therein. Accordingly, the MOS transistor 108 generates an image signal according to the charges held in the first charge holding part 103. Next, the MOS transistor 109 is caused to be conductive such that the image signal generated by the MOS transistor 108 is output to the signal line 12. The operation of resetting the first charge holding part 103 to the operation of outputting the image signal are sequentially performed for each pixel 100 disposed on rows of the pixel array part 10. When image signals in pixels 100 in all rows of the pixel array part 10 are output, a frame that is image signals corresponding to one screen is generated and output from the imaging element 1.

It is possible to reduce a time required for imaging and image signal transfer by performing generation of an image signal in the pixel 100 and output of the image signal in parallel in the aforementioned exposure time. Further, it is possible to prevent occurrence of distortion of a frame and improve picture quality by simultaneously performing exposure in all pixels 100 of the pixel array part 10. In this manner, the second charge holding part 102 is used to temporarily hold charges generated by the photoelectric conversion part 101 at the time of performing the global shutter. Meanwhile, the pixel circuit is an example of an image signal generation circuit described in the claims.

### [Configuration of pixel]

Fig. 3 is a diagram illustrating a configuration example of a pixel according to the first embodiment of the present disclosure. The figure is a plan view showing a configuration example of the pixel 100 and schematically shows disposition of elements such as the photoelectric conversion part 101 described in Fig. 2. In the figure, rectangles indicated by solid lines show the gates 141 to 146 of the MOS transistors 104 to 109 described in Fig. 2. In addition, rectangles indicated by lines of long dashes and two short dashes lines in alteration show semiconductor regions formed in a semiconductor substrate (a semiconductor substrate 110 which will be described later). Further, dotted lines show light-shielding walls 172 and 173 disposed on the semiconductor substrate. Further, a rectangle hatching with diagonal lines shows a dummy gate 131 which will be described later.

In the pixel 100 of the figure, a semiconductor region 111 of the photoelectric conversion part 101 is disposed at the center of the semiconductor substrate. A semiconductor region 112 of the second charge holding part 102 is disposed adjacent to the upper side of the semiconductor region 111 in the figure. The gate 142 of the MOS transistor 105 described in Fig. 2 is disposed near the semiconductor region 112. The MOS transistor 105 is a MOS transistor having the semiconductor regions 111 and 112 as a source region and a drain region. The gate 143 of the MOS transistor 106 is disposed adjacent to the right side of the semiconductor region 112 in the figure, and a semiconductor region 113 of the first charge holding part 103 is disposed adjacent to the gate 143. The MOS transistor 106 is a MOS transistor having the semiconductor regions 112 and 113 as a source region and a drain region.

The gate 144 of the MOS transistor 107 is disposed adjacent to the lower side of the semiconductor region 113 in the figure and a semiconductor region 114 is disposed adjacent to the gate 144. The MOS transistor 107 is a MOS transistor having the semiconductor regions 113 and 114 as a source region and a drain region. The gate 145 of the MOS transistor 108 is disposed adjacent to the lower side of the semiconductor region 114 in the figure and a semiconductor region 115 is disposed adjacent to the gate 145. The MOS transistor 108 is a MOS transistor having the semiconductor regions 114 and 115 as a drain region and a source region. The gate 146 of the MOS transistor 109 is disposed adjacent to the lower side of the semiconductor region 115 in the figure and a semiconductor region 116 is disposed adjacent to the gate 146. The MOS transistor 109 is a MOS transistor having the semiconductor regions 115 and 116 as a drain region and a source region.

Further, the semiconductor region 113 and the gate 145 of the MOS transistor 108 are connected through a wire that is not illustrated. In addition, the gate 141 of the MOS transistor 104 is disposed adjacent to the left side of the semiconductor region 111 in the figure and a semiconductor region 117 is disposed adjacent to the lower side of the gate 141. The MOS transistor 104 is a MOS transistor having the semiconductor regions 111 and 117 as a source region and a drain region.

The light-shielding wall 172 is embedded in a part of the semiconductor substrate on the boundary of the pixel 100 and shields incident light from a neighboring pixel 100. The light-shielding wall 172 is configured in a form in which it penetrates the semiconductor substrate. The light-shielding wall 173 is embedded in a part of the semiconductor substrate between the photoelectric conversion part 101 and the second charge holding part 102 in the pixel 100 and shields incident light from the photoelectric conversion part 101 toward the second charge holding part 102. The light-shielding wall 173 is composed of a part penetrating the semiconductor substrate and a part including an opening (an opening 174 which will be described later) near the front surface of the semiconductor substrate. A part shaded with dotted lines in the light-shielding wall 173 in the figure shows the opening.

The dummy gate 131 is a member constituting a reflection part formation member 130 which will be described later. The dummy gate 131 can be configured as the same member as the gate 142 of the MOS transistor 105 and the like.

Such pixels 100 are disposed in a two-dimensional lattice form to constitute the pixel array part 10. Meanwhile, the semiconductor region 113 in the figure is commonly used by a pixel 100 adjacent to the right side of the pixel 100 in the figure. The gate 141 and the semiconductor region 117 in the figure are commonly used by a pixel 100 adjacent to the left side of the pixel 100 in the figure. Meanwhile, the second charge holding part 102 is an example of a charge holding part described in the claims.

### [Configuration of cross section of pixel]

Fig. 4 is a cross-sectional view illustrating a configuration example of the pixel according to the first embodiment of the present disclosure. The figure shows a configuration example of the pixel 100 and is a cross-sectional view of the pixel 100 along line a-a' in Fig. 3. The pixel 100 in the figure includes a semiconductor substrate 110, the dummy gate 131, a wiring region 160, light-shielding films 150 and 170, the light-shielding walls 172 and 173, an insulating film 180, a color filter 191, an on-chip lens 195, and a supporting substrate 196.

The semiconductor substrate 110 is a semiconductor substrate in which a semiconductor part of an element disposed in the pixel 100 is formed, as described above. The semiconductor substrate 110 can be formed of, for example, silicon (Si). In addition, the semiconductor substrate 110 can be formed to a thickness of 3 µm, for example. The semiconductor part of the element is disposed in a well region formed in the semiconductor substrate 110. For convenience, it is assumed that the semiconductor substrate 110 in the figure is formed in a p type well region. The semiconductor part of the element can be formed by disposing an n type semiconductor region in the p type well region. The photoelectric conversion part 101 and the second charge holding part 102 are illustrated in the figure.

The photoelectric conversion part 101 is configured using the n type semiconductor region 111 in the figure. Specifically, a photodiode configured using a pn junction between the n type semiconductor region 111 and a p type well region around the n type semiconductor region 111 corresponds to the photoelectric conversion part 101. Light incident from the back surface of the semiconductor substrate 110 is photoelectrically converted in the n type semiconductor region 111. Electrons among charges generated through the photoelectric conversion are accumulated in the n type semiconductor region 111 in an exposure period.

The second charge holding part 102 is configured using the n type semiconductor region 112 in the figure. The electrons accumulated in the n type semiconductor region 111 in the exposure period are transferred to the n type semiconductor region 111 and held therein after the lapse of the exposure period. In addition, the gate 142 is disposed on the side of the front surface of the semiconductor substrate 110 near the semiconductor region 112. This gate 142 forms the gate of the aforementioned MOS transistor 105 and controls the potential of the semiconductor region 112. A positive voltage is applied to the gate 142 when the electrons accumulated in the aforementioned semiconductor region 111 are transferred to the semiconductor region 112 to cause the potential of the semiconductor region 112 to be deeper than that of the semiconductor region 111. Accordingly, it is possible to perform complete charge transfer of transferring all charges accumulated in the photoelectric conversion part 101 to the second charge holding part 102.

The gate 142 in the figure can be formed of, for example, polysilicon and can be disposed adjacent to the semiconductor substrate 110 having a gate oxide film interposed therebetween. In addition, a sidewall insulating film 149 can be disposed on the side of the gate 142. The sidewall insulating film 149 is also called a sidewall and is an insulator film formed in a shape that buries a corner part sandwiched between the gate 142 and the semiconductor substrate 110. The sidewall insulating film 149 is an insulating film used as a mask during ion implantation of impurities. An n type semiconductor region that becomes a shallow drain region is formed in the semiconductor substrate 110, the gate 142 and the sidewall insulation film 149 are formed, and then ion implantation is performed to form an n type semiconductor region that becomes a deep drain region. Accordingly, a lightly doped drain (LDD) or the like can be formed in the semiconductor substrate 110.

As shown in the figure, the sidewall insulating film 149 has a front surface having a curved cross section. The sidewall insulating film 149 can be formed of, for example, silicon oxide (SiO₂) and can be formed through etchback. Specifically, the sidewall insulating film 149 can be formed by forming a SiO₂ film to cover the gate 142 and performing anisotropic etching through dry etching to leave SiO₂ attached to the side of the gate 142 and remove SiO₂ of other parts. Here, a silicon nitride (SiN) film can be disposed as a stopper of dry etching.

In addition, the light-shielding walls 172 and 173 are disposed in the semiconductor substrate 110. These light-shielding walls 172 and 173 shield light for the second charge holding part 102 and separate the photoelectric conversion part 101 and the second charge holding part 102 from each other. The light-shielding walls 172 and 173 can be formed by disposing a metal film 171 in a trench formed in the semiconductor substrate 110. As described above, the light-shielding wall 172 is formed in a shape in which it penetrates the semiconductor substrate 110 from the back surface to the front surface thereof. On the other hand, the light-shielding wall 173 is formed in a shape in which a part thereof does not penetrate the semiconductor substrate 110 from the back surface toward the front surface thereof, and an opening 174 is formed at the edge of the light-shielding wall 173. The metal film 171 can be formed of, for example, tungsten (W), aluminum (Al), and copper (Cu).

Further, a fixed charge film and an insulating film can be disposed between the metal film 171 and the trench of the semiconductor substrate 110. Here, the fixed charge film is a film formed of a high dielectric material having negative fixed charges. It is possible to reduce the influence of a trap level formed near the interface of the semiconductor substrate 110 by disposing the fixed charge film. For example, a hafnium oxide film can be used as the fixed charge film. In addition, the insulating film is a film insulating the metal film 171. For example, a SiO₂ film can be used as the insulating film.

In addition, the dummy gate 131 described in Fig. 3 is disposed on the side of the front surface of the semiconductor substrate 110. The dummy gate 131 can be disposed near the opening 174 of the light-shielding wall 173 and can be disposed between the photoelectric conversion part 101 and the second charge holding part 102. Further, the dummy gate 131 can be disposed near the boundary of the photoelectric conversion part 101. A sidewall insulating film 132 can be disposed at the dummy gate 131. The dummy gate 131 and the sidewall insulating film 132 can be respectively formed of the same materials as the gate 142 and the sidewall insulating film 149 and can be formed simultaneously with the gate 142 and the sidewall insulating film 149. In addition, the dummy gate 131 and the sidewall insulating film 132 in the figure constitute the reflection part formation member 130. The bottom surface of the reflection part formation member 130 is disposed adjacent to the front surface of the semiconductor substrate 110, and a reflection part 301 which will be described later is formed on the side thereof. Meanwhile, the dummy gate 131 can be formed of a material other than the aforementioned polysilicon, for example, SiN.

The wiring region 160 is a region disposed on the side of the front surface of the semiconductor substrate 110 and composed of a wiring layer 161 and an insulating layer 169. The wiring layer 161 is a wire through which an electrical signal of an element of the pixel 100 or the like is transmitted. The wiring layer 161 can be formed of, for example, Cu. The insulating layer 169 insulates the wiring layer 161. The insulating layer 169 can be formed of, for example, SiO₂. The insulating layer 169 and the wiring layer 161 can be formed in a multi-layer structure. In the figure, an example of the insulating layer 169 and the wiring layer 161 formed in two layers is shown. Wiring layers 161 in different layers can be connected through a via plug (not illustrated). Meanwhile, the gate 142 of the aforementioned MOS transistor 105 is connected to the wiring layer 161 through a contact plug 162. The contact plug 162 can be formed of, for example, W or Cu.

The light-shielding film 150 is disposed in the wiring region 160. The light-shielding film 150 is disposed on the side of the front surface of the semiconductor substrate 110 and shields reflected light from the wiring layer 161. When incident light transmitted through the semiconductor substrate 110 is reflected by the wiring layer 161, becoming reflected light, and is incident on the second charge holding part 102, photoelectric conversion occurs and causes noise in an image signal. The light-shielding film 150 prevents incidence of the reflected light on the second charge holding part 102. The light-shielding film 150 can be formed of, for example, a metal such as Al, silver (Ag), gold (Au), Cu, platinum (Pt), molybdenum (Mo), chromium (Cr), titanium (Ti), nickel (Ni), W, and iron (Fe). In addition, the light-shielding film 150 can be formed of an alloy including semiconductors such as Si, germanium (Ge) and tellurium (Te) and such metals. Further, the light-shielding film 150 can be formed to a thickness of 200 nm, for example. The light-shielding film 150 in the figure is disposed adjacent to the semiconductor substrate 110, the gate 142, and the sidewall insulating film 149 through an insulator film (insulating film 122 which will be described later).

In addition, the light-shielding film 150 can extend in a region between the photoelectric conversion part 101 and the second charge holding part 102. The light-shielding film 150 in the figure is also disposed adjacent to a region over the side of the reflection part formation member 130. A part of the light-shielding film 150 which adjoins the side of the reflection part formation member 130 forms the reflection part 301. The reflection part 301 reflects transmitted light transmitted through the semiconductor substrate 110 in incident light in the direction of the semiconductor region 111. It is possible to reduce incidence of the transmitted light on the second charge holding part 102 by disposing the reflection part 301. In addition, the shape of the side of the reflection part formation member 130 is transferred to the reflection part 301 because the reflection part 301 is formed adjacent to the side of the reflection part formation member 130. The reflection part 301 in the figure is formed to have a cross section in a curved shape and is formed in a shape in which a concave mirror is extended along the opening 174 of the light-shielding wall 173. Further, the light-shielding film 150 can have an opening 311 disposed near the semiconductor region 111 forming the photoelectric conversion part 101 as shown in the figure.

In addition, a contact wall part 167 and a lid part 168 can be disposed in the wiring region 160 in the figure. The contact wall part 167 is formed in a wall shape in which the bottom thereof adjoins the light-shielding film 150 and encloses the opening 311 of the light-shielding film 150 and reflects transmitted light. The contact wall part 167 can be formed of the same material as the aforementioned light-shielding film 150. When the contact wall part 167 is formed of the same material as the contact plug 162, for example, W or Cu, the contact wall part 167 can be formed simultaneously with the contact plug 162 to simplify a manufacturing process of the imaging element 1. In this case, a Ti film for improving adhesion can be disposed as an underlying metal. In addition, the lid part 168 is formed in a flat plate shape and reflects transmitted light. The lid part 168 is disposed adjacent to the edge of the contact wall part 167 to block the edge of the contact wall part 167. The lid part 168 can be formed of, for example, Cu and formed simultaneously with the wiring layer 161.

It is possible to prevent spread of transmitted light to the wiring region 160 owing to the contact wall part 167 and the lid part 168. In addition, transmitted light is reflected to the semiconductor region 111 forming the photoelectric conversion part 101 to contribute to photoelectric conversion again owing to the contact wall part 167 and the lid part 168. The efficiency of the pixel 100 can be improved. Furthermore, since the contact wall part 167 and the lid part 168 are disposed at a position farther away from the interface of the semiconductor substrate 110 as compared to the light-shielding film 150, formation of a trap level due to diffusion of the metal that is the material thereof can be reduced.

The light-shielding film 170 is a film that is disposed on the side of the back surface of the semiconductor substrate 110 and shields incident light. The light-shielding film 170 shields incident light in a region other than the photoelectric conversion part 101. An opening 175 is disposed in the light-shielding film 170 near the semiconductor region 111 forming the photoelectric conversion part 101. Incident light is radiated to the photoelectric conversion part 101 through the opening 175. The light-shielding film 170 can be formed of the aforementioned metal film 171. That is, the light-shielding film 170 can be formed simultaneously with the light-shielding walls 172 and 173.

The insulating film 180 is a film that insulates the side of the back surface of the semiconductor substrate 110. In addition, the insulating film 180 planarizes the side of the back surface of the semiconductor substrate 110 on which the light-shielding film 170 and the like are formed. Details of the configuration of the insulating film 180 will be described later.

The color filter 191 is an optical filter through which incident light with a predetermined wavelength among incident light is transmitted. A color filter 191 through which any of red light, green light, and blue light is transmitted can be disposed for each pixel 100 as the color filter 191. In addition, a color filter 191 of a complementary color system through which any of cyan light, yellow light, and magenta light is transmitted can also be used in addition to the color filter 191 of a primary color system. Further, a color filter 191 through which infrared light is transmitted can also be used.

The on-chip lens 195 is a lens that concentrates incident light. The on-chip lens 195 is formed in a hemispherical shape and disposed for each pixel 100 and concentrates incident light on the semiconductor region 111 of the photoelectric conversion part 101. The on-chip lens 195 can be formed of, for example, an organic material such as a styrene resin, an acrylic resin, a styrene-acrylic resin, or a siloxane resin. In addition, the on-chip lens 195 can also be formed of an inorganic material such as SiN or silicon oxide nitride (SiON). Further, the on-chip lens 195 can also be formed by dispersing titanium oxide (TiO) particles in the aforementioned organic material or a polyimide resin.

The supporting substrate 196 is a substrate that is disposed adjacent to the wiring region 160. The supporting substrate 196 is a substrate that is disposed mainly to improve the strength of the semiconductor substrate 110 in the manufacturing process of the imaging element 1.

### [Reflection of transmitted light]

Fig. 5 is a diagram illustrating an example of reflection of transmitted light according to the first embodiment of the present disclosure. The figure is an enlarged cross-sectional view of a part of the semiconductor substrate 110 for describing the effect of the reflection part 301. In the figure, the insulating film 180 is composed of a first insulating film 181 and a second insulating film 182. The first insulating film 181 is an insulating film disposed between the metal film 171 and the semiconductor substrate 110 and is a film formed by laminating the aforementioned fixed charge film and an insulator such as SiO₂. In addition, the second insulating film 182 is a film that is formed after disposition of the metal film 171 and insulates and planarizes the metal film 171. Further, the dummy gate 131 is disposed on the front surface of the semiconductor substrate 110 through a gate insulating film 121. In addition, an insulating film 122 is disposed under the light-shielding film 150. The insulating film 122 can be formed of, for example, SiN.

In the figure, A is a diagram showing an example of a case of including the reflection part 301. In the figure, an arrow indicates incident light. Incident light that has transmitted through the semiconductor substrate 110 and reached near the opening 174 of the light-shielding wall 173 is reflected by the reflection part 301 to the side of the semiconductor region 111. In addition, transmitted light can be concentrated on the semiconductor region 111 due to the concave mirror shape of the reflection part 301. Accordingly, photoelectric conversion of the transmitted light becomes possible and thus the sensitivity of the pixel 100 can be improved. Further, when the transmitted light is photoelectrically converted and absorbed in the semiconductor region 111, reflected light projected from the pixel 100 is reduced. Re-incidence of the reflected light from the pixel 100 on a neighboring pixel 100 is reduced and thus flare or color mixing can be reduced.

In addition, it is possible to reduce incidence of transmitted light on the semiconductor region 112 of the second charge holding part 102 owing to the reflection part 301. As described above, when incident light leaks from the photoelectric conversion part 101 to the second charge holding part 102 to cause photoelectric conversion to occur, noise is generated. Such leakage of light to a charge holding part in a global shutter type imaging element is managed as parasitic light sensitivity (PLS). The PLS can be improved by disposing the reflection part 301. In addition, since the reflection part formation member 130 is disposed between the light-shielding film 150 forming the reflection part 301 and the semiconductor substrate 110, the light-shielding film 150 is disposed at a position being away from the semiconductor substrate 110 near the photoelectric conversion part 101. Accordingly, the influence of the light-shielding film 150 on the semiconductor substrate 110 can be reduced.

On the other hand, B in the figure is a diagram showing an example of a case in which the reflection part formation member 130 and the reflection part 301 are omitted and a light-shielding film 501 is disposed instead of the light-shielding film 150. The light-shielding film 501 is also disposed on the front surface of the semiconductor substrate 110 near the photoelectric conversion part 101 and shields transmitted light. It is possible to prevent incidence of transmitted light on the wiring region 160 owing to the light-shielding film 501. However, as indicated by an arrow in B in the figure, transmitted light that has reached near the opening 174 is reflected by the light-shielding film 501 to the side of the second charge holding part 102. Accordingly, noise in an image signal is increased and the PLS is increased. In addition, since the light-shielding film 501 is disposed in proximity to the semiconductor substrate 110 near the photoelectric conversion part 101, the influence thereof on the semiconductor substrate 110 increases. Specifically, a trap level on the side of the front surface of the semiconductor substrate 110 increases and thus a dark current increases. Here, the dark current is a current based on charges generated irrespective of incident light and is a noise component in an image signal. Discharging of charges from the trap level of the semiconductor substrate 110, and the like cause the dark current.

### [Method for manufacturing imaging element]

Figs. 6 to 11 are diagrams illustrating an example of a method for manufacturing the imaging element according to the first embodiment of the present disclosure. Figs. 6 to 11 are diagrams showing a manufacturing process of the imaging element 1. First, the p type well region and the n type semiconductor regions 111 and 112 are formed in the semiconductor substrate 110. This can be performed through ion implantation, for example. Next, the gate insulating film 121 is formed on the front surface of the semiconductor substrate 110. This can be performed through thermal oxidation of the semiconductor substrate 110. Next, the gate 142 and the dummy gate 131 are formed. This can be performed by disposing a film of polysilicon that is the material of the gate 142 and the like and etching the polysilicon film (A in Fig. 6).

Next, a SiO₂ film 401 is formed (B in Fig. 6). This can be performed through chemical vapor deposition (CVD), for example. Further, a SiN film can be disposed under the film 401 as an etching stopper. Next, the film 401 is etched. This etching can be performed through anisotropic etching. Accordingly, the sidewall insulating films 149 and 132 can be formed on the sides of the gate 142 and the dummy gate 131 (C in Fig. 6). Next, the insulating film 122 is disposed on the front surface of the semiconductor substrate 110. This can be performed through CVD, for example (D in Fig. 6). Meanwhile, a manufacturing process of the dummy gate 131 and the sidewall insulating film 132 corresponds to a reflection part formation member disposition process.

Next, a metal film 403 serving as the material of the light-shielding film 150 is disposed on the side of the front surface of the semiconductor substrate 110. This can be performed through CVD or sputtering, for example (E in Fig. 7). Next, the metal film 403 is etched to form the opening 311. In this case, an opening 405 is formed in a region where the light-shielding film 150 of the contact plug 162 is disposed near the gate 142. Accordingly, the light-shielding film 150 can be formed and the reflection part 301 can be formed (F in Fig. 7). Meanwhile, this process corresponds to a reflection part formation process.

Next, an insulating film 406 serving as the material of the insulating layer 169 of the wiring region 160 is disposed. This can be performed through CVD, for example (G in Fig. 7). Next, an opening 407 is formed in a region of the film 406 where the contact plug 162 and the contact wall part 167 will be disposed (H in Fig. 8). Next, a metal film 408 serving as the material of the contact plug 162 is disposed. In this case, the metal film 408 is also disposed in the opening 407. Laminate films of Ti and W are conceivable as the metal film 408. The metal film 408 can be disposed by forming a Ti film through sputtering and forming a W film through CVD to embed the Ti film and the W film in the opening 407. The Ti film can be formed to a thickness of 30 nm, for example (I in Fig. 8). Next, the metal film 408 on the front surface is removed to form the contact plug 162 and the contact wall part 167. This can be performed by grinding the metal film 408 using chemical mechanical polishing (CMP), for example (J in Fig. 8).

Next, an insulating film 409 serving as the material of the insulating layer 169 is disposed (K in Fig. 9). Next, the film 409 is etched to form an opening 410 in a region where the wiring layer 161 and the lid part 168 will be formed (L in Fig. 9). Next, a metal film 411 serving as the material of the wiring layer 161 is disposed. The metal film 411 can be formed of Cu through metal plating (M in Fig. 9). A barrier layer and a seed layer for metal plating can also be disposed under the metal film 411. Next, the metal film 411 is ground through CMP or the like to form the wiring layer 161 and the lid part 168 (N in Fig. 10). Next, an insulating film is disposed on the front surface of the wiring layer 161 and the lid part 168 to form the insulating layer 169 (O in Fig. 10). The wiring region 160 can be formed by repeating disposition of the wiring layer 161 and the insulating film necessary times. Thereafter, the supporting substrate 196 (not illustrated) is attached to the wiring region 160.

Next, the top and bottom of the semiconductor substrate 110 are reversed and thinned. Next, a region of the semiconductor substrate 110 where the light-shielding walls 173 and 174 will be disposed is etched to form an opening 412 (P in Fig. 10). Next, a first insulating film 181 is disposed (Q in Fig. 11). Next, a metal film 413 serving as the light-shielding film 170, the material of the light-shielding walls 173 and 174 is disposed on the back surface of the semiconductor substrate 110. In this case, a metal film 413 is embedded in the opening 412 (R in Fig. 11). Accordingly, the light-shielding walls 173 and 174 can be formed. Next, the metal film 413 is etched to form the opening 175 (S in Fig. 11). Accordingly, the metal film 171 can be formed and the light-shielding film 170 can be formed.

Thereafter, the second insulating film 182, the color filter 191, and the on-chip lens 195 can be disposed to manufacture the imaging element 1. The reflection part 301 in a concave mirror shape can be formed using the shape of the sidewall insulating film 132.

As described above, in the imaging element 1 of the first embodiment of the present disclosure, the reflection part 301 is disposed to reflect transmitted light of the semiconductor substrate 110. Accordingly, leakage of the transmitted light to the second charge holding part 102 is reduced. Therefore, it is possible to reduce mixing of noise into an image signal and alleviate deterioration of picture quality.

### <2. Second embodiment>

In the imaging element 1 of the above-described first embodiment, the reflection part 301 is disposed near the opening 174 of the light-shielding wall 173. On the other hand, an imaging element 1 of the second embodiment of the present disclosure differs from the first embodiment in that a reflection part is disposed to be shifted to a position near the second charge holding part 102.

### [Configuration of cross section of pixel]

Fig. 12 is a cross-sectional view showing a configuration example of a pixel according to the second embodiment of the present disclosure. The figure is a diagram showing a configuration example of the pixel 100 like Fig. 4. The imaging element 1 in the figure differs from the imaging element 1 described in Fig. 4 in that the dummy gate 131 is disposed close to the second charge holding part 102 and a light-shielding film 151 is disposed instead of the light-shielding film 150.

The dummy gate 131 in the figure is disposed at a position close to the semiconductor region 112 forming the second charge holding part 102 of the semiconductor substrate 110 and the sidewall insulating film 132 is disposed at a position in proximity to the sidewall insulating film 149 of the gate 142. Accordingly, the edge of a reflection part 302 in the figure is disposed near the semiconductor region 112 forming the second charge holding part 102. A curved part of the reflection part 302 is disposed immediately under the opening 174 of the light-shielding wall 173, and thus transmitted light at a higher incidence angle can be reflected in the direction of the photoelectric conversion part 101 as compared to the reflection part 301 described in Fig. 4.

Since a configuration of the imaging element 1 other than the aforementioned configuration is the same as the configuration of the imaging element 1 described in the first embodiment of the present disclosure, description thereof will be omitted.

As described above, the imaging element 1 of the second embodiment of the present disclosure reflects transmitted light due to the reflection part 302 disposed to be shifted to a position in proximity to the second charge holding part 102. Accordingly, among transmitted light reaching the opening 174 of the light-shielding wall 173, transmitted light at an incidence angle in a wider range can be reflected and thus leakage of transmitted light to the second charge holding part 102 can be further reduced.

### <3. Third embodiment>

In the imaging element 1 of the above-described first embodiment, the sidewall insulating film 132 is disposed at the dummy gate 131. On the other hand, an imaging element 1 of a third embodiment of the present disclosure differs from the above-described first embodiment in that the sidewall insulating film is omitted.

### [Configuration of cross section of pixel]

Fig. 13 is a cross-sectional view illustrating a configuration example of a pixel according to the third embodiment of the present disclosure. The figure is a diagram showing a configuration example of the pixel 100 like Fig. 4. The imaging element 1 in the figure differs from the imaging element 1 described in Fig. 4 in that a dummy gate 133 and a light-shielding film 152 are disposed instead of the dummy gate 131 and the light-shielding film 150 and the sidewall insulating film 132 is omitted.

The dummy gate 133 in the figure can be formed to have the side in a tapered cross-sectional shape. This can be obtained by disposing a material film serving as the material of the dummy gate 133 on the side of the front surface of the semiconductor substrate 110 and performing etchback. In this case, it is desirable to form the dummy gate 133 using SiO₂ and the like suitable for etchback. A reflection part 303 can be formed by disposing the light-shielding film 152 on the side of the dummy gate 133. As shown in the figure, the reflection part 303 is formed from the light-shielding film 152 disposed obliquely with respect to the semiconductor substrate 110. Meanwhile, in the imaging element 1 in the figure, the dummy gate 133 corresponds to the reflection part formation member.

Since a configuration of the imaging element 1 other than the aforementioned configuration is the same as the configuration of the imaging element 1 described in the first embodiment of the present disclosure, description thereof will be omitted.

As described above, the sidewall insulating film of the reflection part formation member can be omitted in the imaging element 1 of the third embodiment of the present disclosure. Accordingly, it is possible to simplify the configuration of the imaging element 1.

### <4. Fourth embodiment>

In the imaging element 1 of the above-described first embodiment, the reflection part 301 is disposed near the opening 174 of the light-shielding wall 173. On the other hand, an imaging element 1 of a fourth embodiment of the present disclosure differs from the above-described first embodiment in that a reflection part is disposed on a peripheral part of the semiconductor region 111 of the photoelectric conversion part 101.

### [Configuration of pixel]

Fig. 14 is a diagram illustrating a configuration example of a pixel according to the fourth embodiment of the present disclosure. The figure is a plan view showing a configuration example of the pixel 100 like Fig. 3. The pixel 100 in the figure differs from the imaging element 1 described in Fig. 3 in that a dummy gate 134 is disposed instead of the dummy gate 131.

The dummy gate 134 is formed in a square shape having an opening 321 disposed at the center thereof, which is a shape along the peripheral part of the semiconductor region 111 of the photoelectric conversion part 101.

### [Configuration of cross section of pixel]

Fig. 15 is a cross-sectional view showing a configuration example of a pixel according to the fourth embodiment of the present disclosure. The figure is a diagram showing a configuration example of the pixel 100 like Fig. 4. The pixel 100 in the figure differs from the imaging element 1 described in Fig. 4 in that the above-described dummy gate 134 is disposed instead of the dummy gate 131 and a light-shielding film 153 is disposed instead of the light-shielding film 150.

A sidewall insulating film 135 is disposed on the dummy gate 134 in the figure. The sidewall insulating film 135 is formed on the whole perimeter of the side of the outer side of the dummy gate 134. The dummy gate 134 and the sidewall insulating film 135 constitute the reflection part formation member 130. In addition, the light-shielding film 153 in the figure extends at a position over the whole perimeter of the side of the reflection part formation member 130. Accordingly, a reflection part 304 in the figure is formed to have a cross section in a curved shape and formed in a square shape having an opening formed at the center thereof along the peripheral part of the semiconductor region 111 of the photoelectric conversion part 101. The reflection part 304 in a concave mirror shape is disposed on the whole perimeter of the peripheral part of the semiconductor region 111 of the photoelectric conversion part 101, and thus more transmitted light is concentrated on the semiconductor region 111 of the photoelectric conversion part 101.

Meanwhile, the configuration of the reflection part formation member 130 and the reflection part 304 is not limited to this example. For example, when the semiconductor region 111 of the photoelectric conversion part 101 is formed in a cylindrical shape, the reflection part formation member 130 and the reflection part 304 can be formed in a cylindrical shape.

Since a configuration of the imaging element 1 other than the aforementioned configuration is the same as the configuration of the imaging element 1 described in the first embodiment of the present disclosure, description thereof will be omitted.

As described above, the imaging element 1 of the fourth embodiment of the present disclosure includes the reflection part 304 formed in a square shape having an opening formed at the center thereof along the peripheral part of the semiconductor region 111 of the photoelectric conversion part 101. Accordingly, the sensitivity of the pixel 100 can be further improved.

### <5. Fifth embodiment>

The imaging element 1 of the above-described fourth embodiment includes the reflection part formation member 130 in a square shape having an opening formed at the center thereof. On the other hand, an imaging element 1 of a fifth embodiment of the present disclosure differs from the above-described fourth embodiment in that the former includes a reflection part formation member 130 in a rectangular shape in which it covers the semiconductor region 111 of the photoelectric conversion part 101.

### [Configuration of pixel]

Fig. 16 is a diagram illustrating a configuration example of a pixel according to the fifth embodiment of the present disclosure. The figure is a plan view showing a configuration example of the pixel 100 like Fig. 14. The imaging element 1 in the figure differs from the imaging element 1 described in Fig. 14 in that a dummy gate 136 is disposed instead of the dummy gate 134.

The dummy gate 136 is formed in a rectangular shape in which it covers the semiconductor region 111 of the photoelectric conversion part 101.

### [Configuration of cross section of pixel]

Fig. 17 is a cross-sectional view illustrating a configuration example of a pixel according to the fifth embodiment of the present disclosure. The figure is a diagram showing a configuration example of the pixel 100 like Fig. 15. The pixel 100 in the figure differs from the imaging element 1 described in Fig. 15 in that the aforementioned dummy gate 136 is disposed instead of the dummy gate 134, a light-shielding film 154 is disposed instead of the light-shielding film 153, and the contact wall part 167 and the lid part 168 are omitted.

The sidewall insulating film 135 is disposed on the dummy gate 136 in the figure as in the above-described dummy gate 134. The sidewall insulating film 135 is formed on the whole perimeter of the side of the outer side of the dummy gate 136. The dummy gate 136 and the sidewall insulating film 135 constitute the reflection part formation member 130. In addition, the light-shielding film 154 in the figure extends at a position over the upper surface and the side of the reflection part formation member 130 which face the bottom surface thereof. That is, the light-shielding film 154 is formed in a shape in which it covers the side of the front surface of the semiconductor substrate 110 in which the semiconductor region 111 of the photoelectric conversion part 101 is disposed. Accordingly, the vicinity of the photoelectric conversion part 101 of the semiconductor substrate 110 is shielded from light because the light is reflected by the light-shielding film 154. The contact wall part 167 and the lid part 168 of the wiring region 160 can be omitted.

In addition, the light-shielding film 154 is formed of a metal film continuous from the edge of the reflection part 305 to the region of the front surface of the dummy gate 136. Accordingly, variation in the quantity of reflected light at the edge of the reflection part 305 of the light-shielding film 154, and the like can be mitigated. On the other hand, in a case in which the contact wall part 167 and the lid part 168 described in Fig. 15 are included, a reflection direction of reflected light rapidly changes at corner of the contact wall part 167 and the lid part 168 to cause unevenness in the reflected light. In addition, since the light-shielding film 154 is separated from the front surface of the semiconductor substrate 110 due to the dummy gate 136, the influence of the light-shielding film 154 on the semiconductor substrate 110 can be reduced. Further, the reflection part 305 in the figure is formed to have a cross section in a curved shape like the above-described reflection part 304 and formed in a 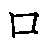 -shape along the peripheral part of the semiconductor region 111 of the photoelectric conversion part 101. Accordingly, increase in the quantity of reflected light concentrated on the semiconductor region 111 of the photoelectric conversion part 101 is conceived.

Meanwhile, the configuration of the reflection part formation member 130 and the reflection part 304 is not limited to this example. For example, when the semiconductor region 111 of the photoelectric conversion part 101 is formed in a cylindrical shape, the above-described reflection part formation member 130 and the reflection part 304 can be formed in a cylindrical shape in the same manner.

A configuration of the imaging element 1 other than the aforementioned configuration is the same as the configuration of the imaging element 1 described in the fourth embodiment of the present disclosure and thus description thereof will be omitted.

As described above, the light-shielding film 154 is formed in a shape in which it covers the semiconductor substrate 110 near the semiconductor region 111 of the photoelectric conversion part 101 in the imaging element 1 of the fifth embodiment of the present disclosure, and thus the configuration of the imaging element 1 can be simplified.

<6. Sixth embodiment>

The imaging element 1 of the above-described fifth embodiment includes the dummy gate 136 in a rectangular shape in which it covers the semiconductor region 111 of the photoelectric conversion part 101. On the other hand, an imaging element 1 of a sixth embodiment of the present disclosure differs from the above-described fifth embodiment in that a bias voltage is applied to the dummy gate 136.

### [Configuration of cross section of pixel]

Fig. 18 is a cross-sectional view illustrating a configuration example of a pixel according to the sixth embodiment of the present disclosure. The figure is a diagram showing a configuration example of the pixel 100 like Fig. 17. The pixel 100 in the figure differs from the imaging element 1 described in Fig. 17 in that the former includes a light-shielding film 155 instead of the light-shielding film 154 and further includes a contact plug 164 and a wiring layer 163 connected to the dummy gate 136.

The dummy gate 136 is connected to the wiring layer 163 through the contact plug 164. A predetermined voltage signal or the like can be applied to the dummy gate 136 like the gate 142. When a negative bias voltage is applied to the dummy gate 136 through the wiring layer 163 and the like, holes can be integrated on the side of the front surface of the semiconductor substrate 110 and thus a hole accumulation region that is a region in which holes have been accumulated can be formed on the surface of the semiconductor substrate 110. A trap level at the front side interface of the semiconductor substrate 110 can be pinned owing to holes of the hole accumulation region, and thus a dark current based on the trap level can be reduced. Meanwhile, the light-shielding film 155 is formed by forming an opening for disposing the contact plug 164 in the light-shielding film 154.

A configuration of the imaging element 1 other than the aforementioned configuration is the same as the configuration of the imaging element 1 described in the fifth embodiment of the present disclosure and thus description thereof will be omitted.

As described above, in the imaging element 1 of the sixth embodiment of the present disclosure, a bias voltage can be applied to the dummy gate 136 having a shape in which it covers the semiconductor substrate 110 near the semiconductor region 111 of the photoelectric conversion part 101. Accordingly, a dark current can be reduced.

### <7. Seventh embodiment>

The imaging element 1 of the above-described first embodiment includes the dummy gate 131. On the other hand, an imaging element 1 of a seventh embodiment of the present disclosure differs from the above-described first embodiment in that the dummy gate 131 is omitted.

### [Configuration of cross section of pixel]

Fig. 19 is a cross-sectional view illustrating a configuration example of a pixel according to the seventh embodiment of the present disclosure. The figure is a diagram showing a configuration example of the pixel 100 like Fig. 4. The imaging element 1 in the figure differs from the imaging element 1 described in Fig. 4 with respect to the following matters. The dummy gate 131, the sidewall insulating film 132, the contact wall part 167, and the lid part 168 are omitted. In addition, the gate 142 and the sidewall insulating film 149 are disposed near the opening 174 of the light-shielding wall 173. Further, a light-shielding film 156 is disposed instead of the light-shielding film 150.

The gate 142 is disposed between the semiconductor region 111 of the photoelectric conversion part 101 and the semiconductor region 112 of the second charge holding part 102 and near the opening 174 of the light-shielding wall 173. When a voltage is applied to the gate 142 through the contact plug 162, a channel is formed in a well region between the semiconductor region 111 and the semiconductor region 112, and thus a region between the photoelectric conversion part 101 and the second charge holding part 102 becomes a conductive state. Accordingly, charges accumulated in the photoelectric conversion part 101 are transferred to the second charge holding part 102. The sidewall insulating film 149 is disposed on the side of the gate 142 and the light-shielding film 156 extends to the side of the sidewall insulating film 149. Accordingly, a reflection part 306 is formed. Meanwhile, the gate 142 and the sidewall insulating film 149 in the figure constitute the reflection part formation member 130.

Further, the configuration of the imaging element 1 is not limited to this example. For example, a configuration in which the contact plug 162 is formed in a wall shape in which it encloses the semiconductor region 111 like the contact wall part 167 and the lid part 168 is disposed can also be employed.

Since a configuration of the imaging element 1 other than the aforementioned configuration is the same as the configuration of the imaging element 1 described in the first embodiment of the present disclosure, description thereof will be omitted.

As described above, the dummy gate 131 and the sidewall insulating film 132 can be omitted in the imaging element 1 of the seventh embodiment of the present disclosure, and thus the configuration of the imaging element 1 can be simplified.

### <8. Eighth embodiment>

The imaging element 1 of the above-described first embodiment includes the dummy gate 131. On the other hand, an imaging element 1 of an eighth embodiment of the present disclosure differs from the above-described first embodiment in that a dummy gate is further laminated.

### [Configuration of cross section of pixel]

Fig. 20 is a cross-sectional view illustrating a configuration example of a pixel according to the eighth embodiment of the present disclosure. The figure is a diagram showing a configuration example of the pixel 100 like Fig. 4. The imaging element 1 in the figure differs from the imaging element 1 described in Fig. 4 in that the former further includes a dummy gate 137 and includes a light-shielding film 157 instead of the light-shielding film 150.

The dummy gate 137 in the figure is formed in such a manner that a part thereof is laminated on the dummy gate 131. Specifically, the dummy gate 137 is disposed over the front surface of the semiconductor substrate 110 and parts of the sidewall insulating film 132 and the dummy gate 131 which close to the second charge holding part 102. The dummy gate 137 is disposed to be laminated on the sidewall insulating film 132, and thus the shape of the sidewall insulating film 132 is transferred to the dummy gate 137 and the dummy gate 137 is formed to have a cross section in a curved shape. The light-shielding film 157 is disposed on the side of the dummy gate 137 to form a reflection part 307. The reflection part formation member 130 in the figure is composed of the dummy gate 137, the dummy gate 131, and the sidewall insulating film 132.

The dummy gates 131 and 137 that are a plurality of films are laminated.to form the reflection part formation member 130. Accordingly, the reflection part formation member 130 can be formed to be thick and formed to have a side with a large curvature. It is possible to increase the size of the reflection part 307 as compared to the reflection part 301 in Fig. 4 by forming the reflection part 307 on the side of the reflection part formation member 130. Accordingly, more transmitted light can be reflected. In addition, the edge of the reflection part 307 is formed on the side of the front surface of the dummy gate 137. Since the reflection part 307 is formed at a position separated from the front surface of the semiconductor substrate 110, a region for forming the reflection part in the surface of the semiconductor substrate 110 can be reduced. Specifically, the gate 142 and the sidewall insulating film 149 can be extended to a region in contact with the sidewall insulating film of the dummy gate 137. Accordingly, a configuration in which the gate 142 is widened to cover a wide range of the semiconductor region 112 of the second charge holding part 102 can be obtained.

Meanwhile, any of the dummy gate 131 and the dummy gate 137 can be formed simultaneously with the gate 142.

Since a configuration of the imaging element 1 other than the aforementioned configuration is the same as the imaging element 1 described in the first embodiment of the present disclosure, description thereof will be omitted.

As described above, in the imaging element 1 of the eighth embodiment of the present disclosure, the reflection part 307 is formed on the side of the reflection part formation member 130 formed by laminating a plurality of dummy gates. Accordingly, the size of the reflection part 307 can be increased and thus more transmitted light can be reflected to the semiconductor region 111 of the photoelectric conversion part 101. Therefore, the sensitivity of the pixel 100 can be further improved.

### <9. Ninth embodiment>

The imaging element 1 of the above-described eighth embodiment includes the gate 142 and the dummy gate 137. On the other hand, an imaging element 1 of a ninth embodiment of the present disclosure differs from the above-described eighth embodiment in that the former includes a gate obtained by connecting the gate 142 and the dummy gate 137.

### [Configuration of cross section of pixel]

Fig. 21 is a cross-sectional view illustrating a configuration example of a pixel according to the ninth embodiment of the present disclosure. The figure is a diagram showing a configuration example of the pixel 100 like Fig. 20. The imaging element 1 in the figure differs from the imaging element 1 described in Fig. 20 in that the former includes a gate 148 instead of the gate 142 and the dummy gate 137.

The gate 148 in the figure is a gate formed in a shape in which the gate 142 in Fig. 20 extends to a part of the dummy gate 131 which is close to the second charge holding part 102. The gate 148 can be used to adjust the potential of the second charge holding part 102 and to form a channel between the semiconductor region 111 of the photoelectric conversion part 101 and the semiconductor region 112 of the second charge holding part 102. It is possible to cause a region between the photoelectric conversion part 101 and the second charge holding part 102 to be conductive and to deepen the potential of the semiconductor region 112 of the second charge holding part 102 by applying a positive voltage to the gate 148. Accordingly, complete transfer of charges from the photoelectric conversion part 101 to the second charge holding part 102 can be achieved.

In addition, the reflection part formation member 130 in the figure is formed by laminating the dummy gate 131 and the gate 148 that are a plurality of films. As can be ascertained from the figure, the gate 148 is formed after the dummy gate 131 and the sidewall insulating film 132 are formed. The reflection part 307 can be formed by disposing the light-shielding film 157 described in Fig. 20 on the formed reflection part formation member 130.

A configuration of the imaging element 1 other than the aforementioned configuration is the same as the configuration of the imaging element 1 described in the eighth embodiment of the present disclosure and thus description thereof will be omitted.

As described above, in the imaging element 1 of the ninth embodiment of the present disclosure, the gate 148 is disposed to extend to the region between the photoelectric conversion part 101 and the second charge holding part 102 to constitute the reflection part formation member 130. Accordingly, it is possible to simplify the configuration of the imaging element 1.

### <10. Tenth embodiment>

In the imaging element 1 of the above-described ninth embodiment, the gate 148 of the second charge holding part 102 is laminated after the dummy gate 131 and the sidewall insulating film 132 are formed to form the reflection part formation member 130. On the other hand, an imaging element 1 of a tenth embodiment of the present disclosure differs from the ninth embodiment in that a dummy gate and a sidewall insulating film are formed after a gate of the second charge holding part 102 is formed.

### [Configuration of cross section of pixel]

Fig. 22 is a cross-sectional view illustrating a configuration example of a pixel according to the tenth embodiment of the present disclosure. The figure is a diagram showing a configuration example of the pixel 100 like Fig. 21. The pixel 100 in the figure differs from the imaging element 1 described in Fig. 21 in that the former includes a gate 147, a dummy gate 138, and a sidewall insulating film 139 instead of the gate 148, the dummy gate 131, and the sidewall insulating film 132.

The gate 147 in the figure is a gate disposed in a region from the vicinity of the photoelectric conversion part 101 to the second charge holding part 102 like the gate 148 in Fig. 21. The dummy gate 138 and the sidewall insulating film 139 are laminated on the gate 147. The gate 147, the dummy gate 138, and the sidewall insulating film 139 constitute the reflection part formation member 130. The reflection part 307 can be formed by disposing a light-shielding film 157 on the reflection part formation member 130. Since the dummy gate 138 and the sidewall insulating film 139 are disposed after the gate 147 is disposed, the dummy gate 138 and the sidewall insulating film 139 can be disposed without affecting the shape of the gate 147.

A configuration of the imaging element 1 other than the aforementioned configuration is the same as the configuration of the imaging element 1 described in the ninth embodiment of the present disclosure and thus description thereof will be omitted.

As described above, in the imaging element 1 of the tenth embodiment of the present disclosure, the dummy gate 138 and the sidewall insulating film 139 are laminated after the gate 147 is formed. Accordingly, the dummy gate 138 can be disposed at an arbitrary position between the photoelectric conversion part 101 and the second charge holding part 102, and thus the position of the reflection part 307 can be easily adjusted.

### <11. Eleventh embodiment>

The imaging element 1 of the above-described first embodiment includes the second charge holding part 102 and performs global shutter type imaging. On the other hand, an imaging element 1 of an eleventh embodiment of the present disclosure differs from the above-described first embodiment in that the second charge holding part 102 is omitted.

### [Circuit configuration of pixel]

Fig. 23 is a diagram illustrating an example of a circuit configuration of a pixel according to the eleventh embodiment of the present disclosure. The figure is a circuit diagram showing a configuration of the pixel 100 like Fig. 2. The pixel 100 in the figure differs from the pixel 100 in Fig. 2 in that the second charge holding part 102 and the MOS transistors 104 and 105 are omitted. The signal line 12 in the figure is composed of signal lines TR, RST, and SEL. The cathode of the photoelectric conversion part 101 is connected to the source of the MOS transistor 103. Connection other than the aforementioned connection is the same as that of the pixel 100 described in Fig. 2 and thus description thereof is omitted.

Generation of an image signal in the pixel 100 in the figure can be performed as follows. First, the MOS transistors 106 and 107 are caused to be conductive to reset the photoelectric conversion part 101 and the first charge holding part 103. The MOS transistor 106 is caused to be conductive after the lapse of a predetermined exposure period such that charges generated in the photoelectric conversion part 101 are transferred to the first charge holding part 103 and held therein. Accordingly, the MOS transistor 108 generates an image signal according to the charges held in the first charge holding part 103. Next, the image signal generated by the MOS transistor 108 can be output to the signal line 12 by causing the MOS transistor 109 to be conductive. Processing from start of exposure to output of an image signal is sequentially performed for respective rows of the pixel array part 10. In this case, an image signal of one frame can be output by shifting an image signal output timing for each row.

This imaging method is called a rolling shutter method. Since exposure timing changes for each row, frame distortion (focal plane distortion) occurs and picture quality deteriorates as compared to the global shutter method. However, the second charge holding part 102 can be omitted and thus the configuration of the pixel 100 can be simplified.

### [Configuration of cross section of pixel]

Fig. 24 is a cross-sectional view illustrating a configuration example of the pixel according to the eleventh embodiment of the present disclosure. The figure is a diagram showing a configuration example of the pixel 100 like Fig. 4. The pixel 100 in the figure differs from the imaging element 1 described in Fig. 4 in that the second charge holding part 102 is omitted, a light-shielding film 179 is included instead of the light-shielding walls 173 and 174 and the light-shielding film 170, and a light-shielding film 158 is included instead of the light-shielding film 150.

Since the pixel 100 in the figure need not include the second charge holding part 102, the proportion of the photoelectric conversion part 101 in the pixel 100 can be improved. The light-shielding film 179 is disposed between the semiconductor substrate 110 and the insulating film 180 on the boundary of the pixel 100 and shields incident light. The reflection part formation member 130 composed of the dummy gate 136 and the sidewall insulating film 135, described in Fig. 17, can be disposed on the side of the front surface of the semiconductor substrate 110. A reflection part 308 can be formed by disposing the light-shielding film 158 adjacent to the dummy gate 136 and the sidewall insulating film 135. The reflection part 308 is disposed near the boundary of the photoelectric conversion part 101.

Meanwhile, the configuration of the pixel 100 is not limited to this example. For example, a configuration in which the contact plug 164 is disposed and a bias voltage is applied thereto like the dummy gate 136 described in Fig. 18 can also be employed. In addition, a configuration including the dummy gate 134, the contact wall part 167, and the lid part 168 described in Fig. 15 can also be employed.

Since a configuration of the imaging element 1 other than the aforementioned configuration is the same as the imaging element 1 described in the first embodiment of the present disclosure, description thereof will be omitted.

As described above, in the imaging element 1 of the eleventh embodiment of the present disclosure, the configuration of the pixel 100 can be simplified by omitting the second charge holding part 102.

### <12. Twelfth embodiment>

In the imaging element 1 of the above-described eleventh embodiment, the reflection part formation member 130 and the reflection part 308 are disposed in all pixels 100. On the other hand, an imaging element 1 of a twelfth embodiment of the present disclosure differs from the above-described eleventh embodiment in that the reflection part formation member 130 and a reflection part are disposed in a pixel 100 corresponding to incident light with a long wavelength.

### [Configuration of cross section of pixel]

Fig. 25 is a cross-sectional view illustrating a configuration example of a pixel according to the twelfth embodiment of the present disclosure. The figure is a diagram showing a configuration example of a pixel like Fig. 24. The imaging element 1 in the figure differs from the imaging element 1 in Fig. 24 in that the former includes a pixel 200 in addition to the pixel 100.

The pixel 100 in the figure includes the reflection part formation member 130 and a reflection part 309 like the pixel 100 described in Fig. 24. In addition, a color filter 191 through which incident light with a long wavelength is transmitted is disposed in the pixel 100 in the figure. Specifically, the color filter 191 through which red light and infrared light are transmitted is disposed in the pixel 100 in the figure. Such light with a long wavelength reaches a deep portion of the semiconductor substrate 110 to increase the quantity of transmitted light. Accordingly, it is possible to prevent deterioration of sensitivity and the like by disposing the reflection part 309.

Meanwhile, a color filter 191 through which incident light with a relatively short wavelength is transmitted is disposed in the pixel 200 in the figure. Specifically, the color filter 191 through which green light and blue light are transmitted is disposed. Such light is absorbed in a relatively shallow region of the semiconductor substrate 110. Accordingly, the reflection part can be omitted.

Meanwhile, the configuration of the pixel 100 is not limited to this example. For example, a configuration in which the contact plug 164 is disposed or a configuration including the dummy gate 134, the contact wall part 167, and the lid part 168 can also be employed.

A configuration of the imaging element 1 other than the aforementioned configuration is the same as the configuration of the imaging element 1 described in the eleventh embodiment of the present disclosure and thus description thereof will be omitted.

As described above, the configuration of the imaging element 1 can be simplified by omitting the reflection part formation member 130 and the reflection part 309 of pixels corresponding to light with a relatively short wavelength in the imaging element 1 of the twelfth embodiment of the present disclosure.

Meanwhile, the shape of the dummy gate of the third embodiment of the present disclosure can be applied to other embodiments. Specifically, the shape of the dummy gate 133 described in Fig. 13 can be applied to the dummy gates in Figs. 15, 17, 18, 20, 21, 22, 24, and 25.

### <13. Example of application to camera>

The technology according to the present disclosure (the present technology) can be applied to various products. For example, the present technology may be realized as an image element mounted in an imaging device such as a camera.

Fig. 26 is a block diagram illustrating a schematic configuration example of a camera that is an example of an imaging device to which the present technology can be applied. A camera 1000 in the figure includes a lens 1001, an imaging element 1002, an imaging control unit 1003, a lens driving unit 1004, an image processing unit 1005, an operation input unit 1006, a frame memory 1007, a display unit 1008, and a recording unit 1009.

The lens 1001 is an imaging lens of the camera 1000. The lens 1001 concentrates light from a subject and causes the concentrated light to be incident on the imaging element 1002 which will be described later to image the subject.

The imaging element 1002 is a semiconductor element that images light from a subject concentrated by the lens 1001. The imaging element 1002 generates an analog image signal in response to radiated light, converts the analog image signal into a digital image signal, and outputs the digital image signal.

The imaging control unit 1003 controls imaging in the imaging element 1002. The imaging control unit 1003 controls the imaging element 1002 by generating a control signal and outputting the control signal to the imaging element 1002. In addition, the imaging control unit 1003 can perform auto-focus in the camera 1000 on the basis of an image signal output from the imaging element 1002. Here, the auto-focus is a system that detects a focal position of the lens 1001 and automatically adjusts the focal position. As the auto-focus, a method of detecting an image surface phase difference according to phase difference pixels disposed in the imaging element 1002 to detect a focal position (image surface phase difference auto-focus) can be used. In addition, a method of detecting a position at which the contrast of an image is maximized as a focal position (contrast auto-focus) can also be applied. The imaging control unit 1003 adjusts the position of the lens 1001 through the lens driving unit 1004 on the basis of the detected focal position and performs auto-focus. Meanwhile, the imaging control unit 1003 can be configured as, for example, a digital signal processor (DSP) provided with firmware.

The lens driving unit 1004 drives the lens 1001 on the basis of control of the imaging control unit 1003. The lens driving unit 1004 can drive the lens 1001 by changing the position of the lens 1001 using a motor embedded therein.

The image processing unit 1005 processes an image signal generated by the imaging element 1002. This processing corresponds to, for example, demosaicing for generating an image signal of an omitted color among image signals corresponding to red, green, and blue for each pixel, noise reduction for removing noise in an image signal, image signal encoding, and the like. The image processing unit 1005 can be configured as, for example, a microcomputer provided with firmware.

The operation input unit 1006 receives an operation input from a user of the camera 1000. For example, a press button or a touch panel can be used as the operation input unit 1006. An operation input received by the operation input unit 1006 is transmitted to the imaging control unit 1003 and the image processing unit 1005. Thereafter, processing in response to the operation input, for example, processing of imaging a subject, and the like is started.

The frame memory 1007 is a memory storing a frame that is an image signal corresponding to one screen. The frame memory 1007 is controlled by the image processing unit 1005 and holds frames in a procedure of image processing.

The display unit 1008 displays an image processed by the image processing unit 1005. For example, a liquid crystal panel can be used as the display unit 1008.

The recording unit 1009 records an image processed by the image processing unit 1005. For example, a memory card or a hard disk can be used as the recording unit 1009.

The camera to which the present disclosure can be applied has been described above. The present technology can be applied to the imaging element 1002 among the components described above. Specifically, the imaging element 1 described in Fig. 1 can be applied to the imaging element 1002. The influence of reflected light on pixels is reduced by applying the imaging element 1 to the imaging element 1002, and thus deterioration of picture quality of images generated by the camera 1000 can be prevented. Meanwhile, the image processing unit 1005 is an example of a processing circuit described in the claims. The camera 1000 is an example of an imaging device described in the claims.

Meanwhile, although the camera has been described as an example here, the technology according to the present disclosure may be applied to, for example, a monitoring device and the like in addition thereto. In addition, the present disclosure can also be applied to a semiconductor device in the form of a semiconductor module in addition to electronic apparatuses such as the camera. Specifically, the technology according to the present disclosure can also be applied to an imaging module that is a semiconductor module in which the imaging element 1002 and the imaging control unit 1003 of Fig. 26 are encapsulated in a single package.

Finally, description of each of the above-described embodiments is an example of the present disclosure and the present disclosure is not limited to the above-described embodiments. Accordingly, it is needless to say that various modifications can be made depending on design and the like without departing from the technical spirit according to the present disclosure in addition to the above-described embodiments.

In addition, the drawings in the above-described embodiments are schematic and dimensional ratios and the like of respective parts are not necessarily consistent with real ones. In addition, it is needless to say that drawings include parts where dimensional relationships and ratios differ between the drawings.

The present technology can be configured as follows.
(1) An imaging element including a photoelectric conversion part that is formed in a semiconductor substrate and performs photoelectric conversion of incident light,
   a reflection part that is disposed in a front surface of the semiconductor substrate which is different from a surface on which the incident light is incident and reflects transmitted light transmitted through the photoelectric conversion part to the photoelectric conversion part, and
   a reflection part formation member having a bottom surface disposed adjacent to the front surface of the semiconductor substrate and a side on which the reflection part is formed.
(2) The imaging element according to (1), further including an image signal generation circuit that generates an image signal on the basis of charges generated through the photoelectric conversion.
(3) The imaging element according to (2), wherein the reflection part formation member is formed simultaneously with a gate of a MOS transistor disposed in the image signal generation circuit.
(4) The imaging element according to (2), wherein the reflection part formation member is formed of the gate of the MOS transistor disposed in the image signal generation circuit.
(5) The imaging element according to any one of (1) to (4), wherein the reflection part formation member has a sidewall insulating film disposed on the side, and
   the reflection part is formed adjacent to the sidewall insulating film.
(6) The imaging element according to any one of (1) to (5), wherein the reflection part is disposed near a boundary of the photoelectric conversion part in the semiconductor substrate.
(7) The imaging element according to (6), further including a light-shielding film that is formed adjacent to an upper surface of the reflection part formation member, which is a surface opposite to the bottom surface, to shield the transmitted light.
(8) The imaging element according to any one of (1) to (7), further including a charge holding part that holds the charges generated through the photoelectric conversion.
(9) The imaging element according to (8), further including a light-shielding wall disposed between the photoelectric conversion part in the semiconductor substrate and the charge holding part.
(10) The imaging element according to (9), wherein the light-shielding wall includes an opening near the front surface of the semiconductor substrate, and
   the reflection part is disposed near the opening of the light-shielding wall.
(11) The imaging element according to (10), wherein the reflection part is disposed to be shifted toward the charge holding part from the opening of the light-shielding wall.
(12) The imaging element according to any one of (1) to (11), wherein the reflection part formation member is formed by laminating a plurality of films.
(13) The imaging element according to (12), further including an image signal generation circuit that generates an image signal on the basis of the charges generated through the photoelectric conversion,
   wherein any one of the plurality of films of the reflection part formation member is formed simultaneously with a gate of a MOS transistor of the image signal generation circuit.
(14) The imaging element according to any one of (1) to (13), wherein a bias voltage is applied to the reflection part formation member.
(15) The imaging element according to any one of (1) to (14), wherein the side of reflection part formation member is formed in a curved shape.
(16) The imaging element according to any one of (1) to (14), wherein the reflection part formation member includes a side having a cross section in a tapered shape.
(17) The imaging element according to any one of (1) to (16), further including a color filter through which incident light with a predetermined wavelength is transmitted,
   wherein the photoelectric conversion part performs photoelectric conversion of incident light transmitted through the color filter.
(18) The imaging element according to (17), including a plurality of pixels each having the photoelectric conversion part and the color filter,
   wherein the reflection part and the reflection part formation member are disposed in a pixel in which the color filter through which the incident light with a long wavelength is transmitted is disposed among the plurality of pixels.
(19) The imaging element according to any one of (1) to (18), wherein the reflection part is formed of a metal.
(20) An imaging device including a photoelectric conversion part that is formed in a semiconductor substrate and performs photoelectric conversion of incident light,
   a reflection part that is disposed in a front surface of the semiconductor substrate which is different from a surface on which the incident light is incident and reflects transmitted light transmitted through the photoelectric conversion part to the photoelectric conversion part, and
   a reflection part formation member having a bottom surface disposed adjacent to the front surface of the semiconductor substrate and a side on which the reflection part is formed, and
   a processing circuit that processes an image signal generated on the basis of charges generated through the photoelectric conversion.

### [Reference Signs List]

1 Imaging element
10 Pixel array part
30 Column signal processing unit
100, 200 Pixel
101 Photoelectric conversion part
102 Second charge holding part
103 First charge holding part
104 to 109 MOS transistor
110 Semiconductor substrate
111 to 117 Semiconductor region
121 Gate insulating film
122, 180 to 182 Insulating film
130 Reflection part formation member
131, 133, 134, 136 to 138Dummy gate
132, 135, 139, 149 Sidewall insulating film
141 to 148 Gate
150, 152 to 158 Light-shielding film
151, 169 Insulating layer
160 Wiring region
161, 163 Wiring layer
162, 164 Contact plug
167 Contact wall part
168 Lid part
170, 179 Light-shielding film
171 Metal film
172, 173 Light-shielding wall
174, 175, 311, 321 Opening
191 Color filter
301 to 309 Reflection part
1000 Camera
1002 Imaging element
1005 Image processing unit

## Claims

1. An imaging element comprising:
a photoelectric conversion part that is formed in a semiconductor substrate and performs photoelectric conversion of incident light;
a reflection part that is disposed in a front surface of the semiconductor substrate which is different from a surface on which the incident light is incident and reflects transmitted light transmitted through the photoelectric conversion part to the photoelectric conversion part; and
a reflection part formation member having a bottom surface disposed adjacent to the front surface of the semiconductor substrate and a side on which the reflection part is formed.

2. The imaging element according to claim 1, further comprising an image signal generation circuit that generates an image signal on the basis of charges generated through the photoelectric conversion.

3. The imaging element according to claim 2, wherein the reflection part formation member is formed simultaneously with a gate of a MOS transistor disposed in the image signal generation circuit.

4. The imaging element according to claim 2, wherein the reflection part formation member is formed of the gate of the MOS transistor disposed in the image signal generation circuit.

5. The imaging element according to claim 1, wherein the reflection part formation member has a sidewall insulating film disposed on the side part, and
the reflection part is formed adjacent to the sidewall insulating film.

6. The imaging element according to claim 1, wherein the reflection part is disposed near a boundary of the photoelectric conversion part in the semiconductor substrate.

7. The imaging element according to claim 6, further comprising a light-shielding film that is formed adjacent to an upper surface of the reflection part formation member, which is a surface opposite to the bottom surface, to shield the transmitted light.

8. The imaging element according to claim 1, further comprising a charge holding part that holds the charges generated through the photoelectric conversion.

9. The imaging element according to claim 8, further comprising a light-shielding wall disposed between the photoelectric conversion part in the semiconductor substrate and the charge holding part.

10. The imaging element according to claim 9, wherein the light-shielding wall includes an opening near the front surface of the semiconductor substrate, and
the reflection part is disposed near the opening of the light-shielding wall.

11. The imaging element according to claim 10, wherein the reflection part is disposed to be shifted toward the charge holding part from the opening of the light-shielding wall.

12. The imaging element according to claim 1, wherein the reflection part formation member is formed by laminating a plurality of films.

13. The imaging element according to claim 12, further comprising an image signal generation circuit that generates an image signal on the basis of the charges generated through the photoelectric conversion,
wherein any one of the plurality of films of the reflection part formation member is formed simultaneously with a gate of a MOS transistor of the image signal generation circuit.

14. The imaging element according to claim 1, wherein a bias voltage is applied to the reflection part formation member.

15. The imaging element according to claim 1, wherein the side of the reflection part formation member is formed in a curved shape.

16. The imaging element according to claim 1, wherein the reflection part formation member includes a side having a cross section in a tapered shape.

17. The imaging element according to claim 1, further comprising a color filter through which incident light with a predetermined wavelength is transmitted,
wherein the photoelectric conversion part performs photoelectric conversion of incident light transmitted through the color filter.

18. The imaging element according to claim 17, comprising a plurality of pixels each having the photoelectric conversion part and the color filter,
wherein the reflection part and the reflection part formation member are disposed in a pixel in which the color filter through which the incident light with a long wavelength is transmitted is disposed among the plurality of pixels.

19. The imaging element according to any one of claims 1 to 4, wherein the reflection part is formed of a metal.

20. An imaging device comprising:
a photoelectric conversion part that is formed in a semiconductor substrate and performs photoelectric conversion of incident light;
a reflection part that is disposed in a front surface of the semiconductor substrate which is different from a surface on which the incident light is incident and reflects transmitted light transmitted through the photoelectric conversion part to the photoelectric conversion part;
a reflection part formation member having a bottom surface disposed adjacent to the front surface of the semiconductor substrate and a side on which the reflection part is formed; and
a processing circuit that processes an image signal generated on the basis of charges generated through the photoelectric conversion.
